# EUROPEAN PATENT APPLICATION

(11) **EP 4 637 290 A1**
(43) Date of publication of application: **22.10.2025**
(21) Application number: 24220497.2
(22) Date of filing: 17.12.2024
(51) Int. Cl.: H10B 12/00, H10D 1/68

(54) **SEMICONDUCTOR MEMORY DEVICE**

(30) Priority: 15.04.2024 KR 20240050166
(71) Applicant: Samsung Electronics Co., Ltd., Suwon-si, Gyeonggi-do 16677 (KR)
(72) Inventor: RYU, Dong Gyun, 16677 Suwon-si, Gyeonggi-do (KR); KIM, Inji, 16677 Suwon-si, Gyeonggi-do (KR); KIM, Jin-Ho, 16677 Suwon-si, Gyeonggi-do (KR); JI, Hyun Seok, 16677 Suwon-si, Gyeonggi-do (KR)
(74) Representative: Kuhnen & Wacker Patent- und Rechtsanwaltsbüro PartG mbB

(57) **Abstract**

A semiconductor memory device comprising, a substrate (100), a plurality of lower electrodes (130) on the substrate (100), and a supporter (150) connecting the plurality of lower electrodes (130) to each other, wherein the supporter (150) includes a plurality of supporter holes (150_H) adj acent to some of the plurality of lower electrodes (130), the plurality of lower electrodes (130) include a plurality of first lower electrodes (132) adjacent to the plurality of supporter holes (150_H) and a plurality of second lower electrodes (134) spaced apart from the plurality of supporter holes (150_H), four adjacent first lower electrodes (132_1, 132_2, 132_3, 132_4) of the plurality of first lower electrodes (132) are adjacent to one of the plurality of supporter holes (150_H), and the plurality of supporter holes are at equal intervals in a first direction (D6) and a second direction (D7) crossing the first direction (D6).

## Description

### BACKGROUND OF THE INVENTION

### Field

The present disclosure relates to a semiconductor memory device.

### Description of Related Art

A semiconductor device is a core component used to control or amplify an electrical signal in an electronic device, and various types of semiconductor devices may be manufactured. For example, a memory device may be mainly used to store and retrieve data, while a non-memory device may be used to control or amplify an electrical signal. The semiconductor device is a core component of an electronic device and plays an important role in various fields including computers, communication equipment, consumer electronics, etc.

With the development of the electronics industry, the performance and function requirements of the electronic devices are also increasing. Accordingly, high-performance characteristics of the semiconductor devices may be required, and the degree of integration of the semiconductor devices is increasing to meet these requirements. For example, there may be a need for a technology that can improve the degree of integration of dynamic random access memory (DRAM) devices and form capacitors with excellent electrical characteristics.

### SUMMARY OF THE INVENTION

In order to solve one or more problems (e.g., the problems described above and/or other problems not explicitly described herein), the present disclosure provides a semiconductor memory device with improved electrical characteristics and reliability.

According to some embodiments of the present disclosure, a semiconductor memory device comprising, a substrate, a plurality of lower electrodes on the substrate, and a supporter connecting the plurality of lower electrodes to each other, wherein the supporter includes a plurality of supporter holes adjacent to some of the plurality of lower electrodes, the plurality of lower electrodes include a plurality of first lower electrodes adjacent to the plurality of supporter holes and a plurality of second lower electrodes spaced apart from the plurality of supporter holes, four adjacent first lower electrodes of the plurality of first lower electrodes are adjacent to one of the plurality of supporter holes, and the plurality of supporter holes are at equal intervals in a first direction and a second direction crossing the first direction.

According to some embodiments of the present disclosure, a semiconductor memory device comprising, a substrate, a plurality of lower electrodes on the substrate, and a supporter connecting the plurality of lower electrodes to each other, wherein the supporter includes a plurality of supporter holes adjacent to some of the plurality of lower electrodes, the plurality of lower electrodes include a plurality of first lower electrodes adjacent to the plurality of supporter holes and a plurality of second lower electrodes spaced apart from the plurality of supporter holes, the plurality of supporter holes are aligned and spaced apart from each other by a first distance in a first direction, the plurality of supporter holes are aligned and spaced apart from each other by a second distance different from the first distance in a second direction perpendicular to the first direction, and a number of the second lower electrodes between a first pair of adjacent supporter holes of the plurality of supporter holes in the first direction is greater than a number of the second lower electrodes between a second pair of adjacent supporter holes of the plurality of supporter holes in the second direction.

According to some embodiments of the present disclosure, a semiconductor memory device comprising, a substrate including a transistor, a capacitor structure on the substrate and electrically connected to the transistor, the capacitor structure including a plurality of lower electrodes electrically connected to the transistor, an upper electrode on the plurality of lower electrodes, and a dielectric film between the plurality of lower electrodes and the upper electrode, and a supporter connecting the plurality of lower electrodes to each other, wherein the supporter includes a plurality of supporter holes adjacent to some of the plurality of lower electrodes, the plurality of lower electrodes include a plurality of first lower electrodes adjacent to the plurality of supporter holes and a plurality of second lower electrodes spaced apart from the plurality of supporter holes, four adjacent first lower electrodes of the plurality of first lower electrodes are adjacent to one of the plurality of supporter holes, and a ratio of a number of the first lower electrodes to a number of the second lower electrodes is 1:1.

According to some embodiments of the present disclosure, the first lower electrode adjacent to the supporter hole and the second lower electrode spaced apart from the supporter hole are symmetrically located, so that the reliability of the semiconductor memory devices can be improved.

### BRIEF DESCRIPTION OF THE DRAWINGS

The above and other aspects and features of the present disclosure will become more apparent by describing in detail example embodiments thereof with reference to the attached drawings, in which:
FIG. 1 is a plan view provided to explain a semiconductor memory device according to some embodiments of the present disclosure;
FIG. 2 is a cross-sectional view taken along line A-A of FIG. 1;
FIG. 3 is a plan view provided to explain a semiconductor memory device according to some embodiments of the present disclosure;
FIGS. 4 to 7 are diagrams provided to explain a semiconductor memory device according to some embodiments of the present disclosure;
FIG. 8 is a plan view provided to explain a semiconductor memory device according to some embodiments of the present disclosure;
FIG. 9 is a plan view provided to explain a semiconductor memory device according to some embodiments of the present disclosure;
FIG. 10 is a diagram provided to explain a semiconductor memory device according to some embodiments of the present disclosure;
FIG. 11 is a diagram provided to explain a semiconductor memory device according to some embodiments of the present disclosure;
FIG. 12 is a diagram provided to explain a semiconductor memory device according to some embodiments of the present disclosure;
FIGS. 13 and 14 are diagrams provided to explain a semiconductor memory device according to some embodiments of the present disclosure;
FIGS. 15 and 16 are diagrams provided to explain a semiconductor memory device according to some embodiments of the present disclosure;
FIGS. 17 to 25 are diagrams showing intermediate stages, provided to explain a method for manufacturing a semiconductor memory device according to some embodiments of the present disclosure.

### DETAILED DESCRIPTION

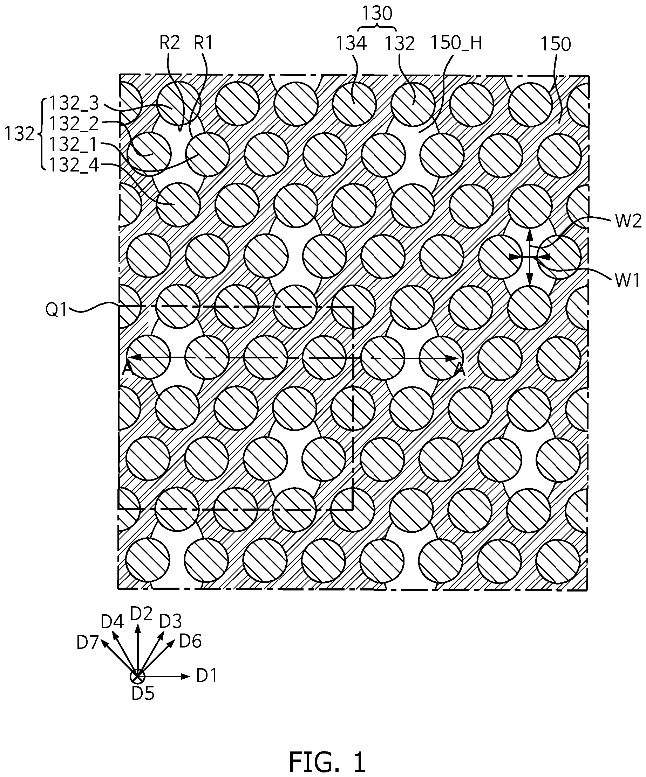

A semiconductor memory device according to some embodiments of the present disclosure will be described with reference to FIGS. 1 to 2.

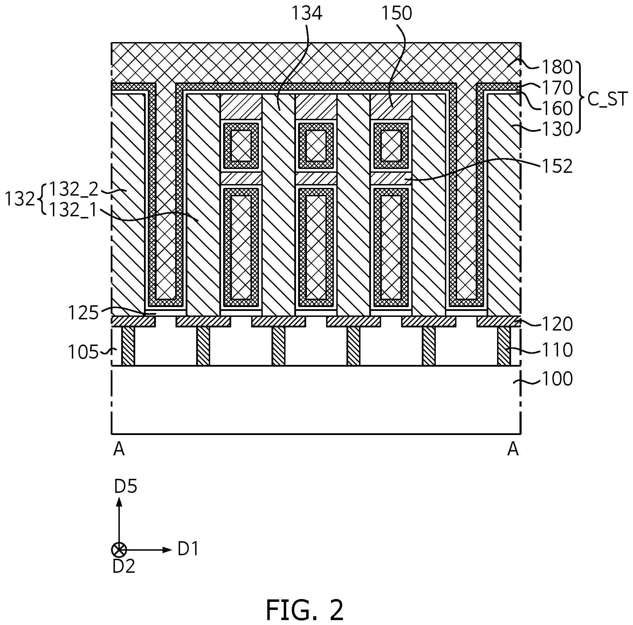

FIG. 1 is a plan view provided to explain a semiconductor memory device according to some embodiments of the present disclosure. FIG. 2 is a cross-sectional view taken along line A-A of FIG. 1. For convenience of description, configurations other than a first supporter 150 and a lower electrode 130 are omitted in FIG. 1.

Referring to FIGS. 1 and 2, a semiconductor memory device according to some embodiments of the present disclosure may include a substrate 100, an interlayer insulating film 105, contact plugs 110, landing pads 120, first supporters 150, second supporters 152, and capacitor structures C_ST.

The substrate 100 may be, for example, a bulk silicon substrate or a silicon-on-insulator (SOI) substrate. In other examples, the substrate 100 may include silicon germanium (SiGe), silicon germanium on insulator (SGOI), indium antimony, lead tellurium compound, indium arsenic, indium phosphide, gallium arsenic, or gallium antimony, but is not limited thereto.

The semiconductor memory device according to some embodiments may include a transistor in the substrate 100. The semiconductor memory device may be an assembly of memory devices including at least one transistor and at least one data storage structure. The semiconductor memory device may be a DRAM or a ferroelectric memory (FeRAM).

The interlayer insulating film 105 may be disposed on the substrate 100. The landing pads 120 may be disposed on top of the interlayer insulating film 105. The contact plugs 110 may be disposed in the interlayer insulating film 105. The contact plugs 110 may be connected to the landing pads 120. For example, the contact plugs 110 may electrically connect a transistor disposed in the substrate 100 to the landing pads 120.

For example, the interlayer insulating film 105 may include at least one of silicon oxide (SiO), silicon nitride (SiN), silicon oxynitride (SiON), silicon oxycarbonitride (SiOCN), and a combination thereof. For example, the contact plug 110 may include at least one of an impurity-doped semiconductor material, a conductive silicide compound, a conductive metal nitride, and a metal. For example, the landing pads 120 may include at least one of an impurity-doped semiconductor material, a conductive silicide compound, a conductive metal nitride, and a metal. In some examples, the landing pads 120 may include tungsten (W).

An etching stop (or "etch stop") film 125 may be disposed on the interlayer insulating film 105. The etching stop film 125 may be disposed on the landing pads 120. The etching stop film 125 may be absent from (e.g., may expose) at least portions of the landing pads 120. For example, the etching stop film 125 may include openings exposing at least the portions of the landing pads 120.

For example, the etching stop film 125 may include at least one of silicon nitride (SiN), silicon carbon nitride (SiCN), silicon boron nitride (SiBN), silicon carbonate (SiCO), silicon oxynitride (SiON), silicon oxide (SiO), and silicon oxycarbonitride (SiOCN). In the present disclosure, a compound such as silicon carbonate (SiCO) includes silicon (Si), carbon (C), and oxygen (O), but it does not mean a ratio between silicon (Si), carbon (C), and oxygen (O).

The capacitor structures C_ST may be disposed on the substrate 100. The capacitor structures C_ST may store a signal received from the transistor in the substrate 100. The capacitor structure C_ST may be used as a data storage element electrically connected to the transistor. For example, the capacitor structure C_ST may store electric charges under the control of the transistor.

The capacitor structure C_ST may include the lower electrodes 130, a dielectric film 160, a conductive film 170, and an upper electrode 180.

A plurality of lower electrodes 130 may be disposed on the substrate 100. Each of the lower electrodes 130 may be disposed on the landing pad 120. The landing pad 120 may be disposed between the substrate 100 and the lower electrode 130. The lower electrode 130 may be electrically connected to the landing pad 120. A portion of the lower electrode 130 may be disposed in the etching stop film 125. For example, the lower electrode 130 may extend through the etching stop film 125 and be connected to the landing pad 120.

The lower electrodes 130 may be arranged in an array, such as in a hexagonal honeycomb structure. For example, the lower electrodes 130 may be disposed at each vertex and center of the hexagon, and the hexagonal structure in which the lower electrodes are arranged may be repeated. Specifically, the lower electrodes 130 may be aligned at distances from each other in a first direction D1 and a second direction D2. The lower electrodes 130 may be arranged at equal intervals in the first direction D1. The lower electrodes 130 may be arranged in a staggered fashion in the second direction D2. The lower electrodes 130 may be linearly arranged along third and fourth directions D3 and D4.

The first direction D1 and the second direction D2 may be perpendicular to each other. The third direction D3 may cross the first and second directions D1 and D2. The fourth direction D4 may cross the first and second directions D1 and D2. Each of the first to fourth directions D1, D2, D3, and D4 may cross each other. In some examples, an angle formed by the third direction D3 and the fourth direction D4 and an angle formed by the first direction D1 and the third direction D3 may be 60 degrees, respectively. However, the present disclosure is not limited thereto.

In some examples, the lower electrode 130 may have a vertical rectangular (e.g., pillar) shape. The lower electrode 130 may extend in a fifth direction D5. The fifth direction D5 may be a thickness direction of the substrate 100. In other words, the fifth direction D5 may be a direction perpendicular to an upper surface of the landing pad 120. The fifth direction D5 may be perpendicular to each of the first to fourth directions D1, D2, D3, and D4.

For example, the lower electrode 130 may include at least one of a conductive metal material (cobalt (Co), titanium (Ti), nickel (Ni), tungsten (W), molybdenum (Mo), etc.), a metal nitride (titanium nitride (TiN), titanium silicon nitride (TiSiN), titanium aluminum nitride (TiAlN), tantalum aluminum nitride (TaAlN), tungsten nitride (WN), etc.), a noble metal material (platinum (Pt), ruthenium (Ru), iridium (Ir), etc.), a conductive oxide film (PtO, RuO₂, IrO₂, SRO(SrRuO₃), BSRO((Ba,Sr)RuO₃), CRO(CaRuO₃), LSCo, etc.), and metal silicide films. However, the present disclosure is not limited thereto.

The first supporter 150 and the second supporter 152 may be disposed in the capacitor structure C_ST. However, it is to be understood that this is only an example. In some examples, only one of the first supporter 150 and the second supporter 152 may be disposed in the capacitor structure C_ST, or one or more additional supporters may be further disposed in addition to the first supporter 150 and the second supporter 152.

The first supporter 150 and the second supporter 152 may be disposed between the plurality of lower electrodes 130. The first supporter 150 and the second supporter 152 may be disposed between adjacent lower electrodes 130. The first supporter 150 and the second supporter 152 may be in contact with the lower electrodes 130. The first supporter 150 and the second supporter 152 may connect and support the adjacent lower electrodes 130.

The first supporter 150 and the second supporter 152 may be spaced apart from each other in the fifth direction D5. The first supporter 150 may be disposed on the second supporter 152. For example, the first supporter 150 may be disposed to be further spaced apart than the second supporter 152 from the substrate 100 in the fifth direction D5. The dielectric film 160, the conductive film 170, and the upper electrode 180 may be disposed between the first supporter 150 and the second supporter 152. The first supporter 150 and the second supporter 152 may overlap each other in the fifth direction D5.

An upper surface of the first supporter 150 may be coplanar with an upper surface of the lower electrode 130. However, it is to be understood that this is only an example. In some examples, the upper surface of the lower electrode 130 may be lower or higher than the upper surface of the first supporter 150.

The second supporter 152 may be disposed on the etching stop film 125. The second supporter 152 may be spaced apart from the etching stop film 125 in the fifth direction D5. The dielectric film 160, the conductive film 170, and the upper electrode 180 may be disposed between the second supporter 152 and the etching stop film 125.

In some examples, the thickness of the first supporter 150 and the thickness of the second supporter 152 may be different from each other. The thickness of the first supporter 150 and the thickness of the second supporter 152 may refer to a thickness in the fifth direction D5. For example, the thickness of the first supporter 150 may be greater than the thickness of the second supporter 152. However, the present disclosure is not limited thereto. Unlike the illustration, the thickness of the first supporter 150 may be equal to or less than the thickness of the second supporter 152.

In some examples, with respect to the fifth direction D5, a distance between the first supporter 150 and the second supporter 152 may be less than a distance between the second supporter 152 and the etching stop film 125. However, the present disclosure is not limited thereto. Unlike the illustration, the distance between the first supporter 150 and the second supporter 152 may be equal to or greater than the distance between the second supporter 152 and the etching stop film 125.

For example, each of the first supporter 150 and the second supporter 152 may include at least one of silicon oxynitride (SiON), silicon nitride (SiN), silicon carbon nitride (SiCN), and tantalum oxide (TaO). In some examples, the first supporter 150 and the second supporter 152 may include the same material, but the present disclosure is not limited thereto. For example, the first supporter 150 and the second supporter 152 may include different materials from each other.

The first supporter 150 may include a supporter hole 150_H (FIG. 1) overlapping/exposing (e.g., adjacent to) a portion of the lower electrode 130. As used herein with respect to the supporter hole 150_H and one or more lower electrodes 130, the term "adjacent" means that no other lower electrode 130 is between the supporter hole 150_H and the lower electrodes 130. Moreover, the adjacent lower electrode(s) 130 may be on a perimeter of the supporter hole 150_H, as shown in FIG. 1. Other lower electrodes 130 may be spaced apart from the perimeter of the supporter hole 150_H. The second supporter 152 may include a supporter hole overlapping/exposing a portion of the lower electrode 130. The supporter hole of the second supporter 152 may be aligned with the supporter hole 150_H of the first supporter 150 in the fifth direction D5. The description of the arrangement of the supporter holes of the second supporters 152 may be substantially the same as the description of the supporter holes 150_H of the first supporters 150. For example, the arrangement of the supporter holes of the second supporters 152 may be the same as the supporter holes 150_H of the first supporters 150 except that they are spaced apart in the fifth direction D5. Hereinafter, the supporter hole 150_H of the first supporter 150 will be mainly described with reference to FIG. 1.

The first supporter 150 may include a plurality of supporter holes 150_H. For example, the term "supporter," as used herein, may refer to a structure (e.g., the first supporter 150 shown in FIG. 1) that includes the supporter holes 150_H shown in FIG. 1. The structure referred to by the term "supporter" may thus also include multiple segments/portions of the first supporter 150, as shown, for example, in FIG. 2 (which is a cross-sectional view in which the segments/portions are spaced apart from each other in the direction D1). The supporter holes 150_H may overlap/expose at least a portion of the lower electrode 130. For example, the supporter hole 150_H may overlap/expose a portion of a side surface (i.e., a sidewall) of the lower electrode 130. The supporter hole 150_H may be adjacent to (e.g., may overlap/expose) some (but not all) of the plurality of lower electrodes 130. One supporter hole 150_H may overlap/expose the four lower electrodes 130. For example, one supporter hole 150_H may overlap/expose four adjacent lower electrodes 130. As an example, the four adjacent lower electrodes 130 may all be adjacent to (e.g., on a perimeter of) the one supporter hole 150_H.

The supporter holes 150_H may be aligned at distances from each other in the first direction D1. The supporter holes 150_H may be aligned at distances from each other in the second direction D2. A distance between supporter holes 150_H adj acent in the first direction D1 may be greater than a distance between supporter holes 150_H adjacent in the second direction D2.

The supporter holes 150_H may be aligned at distances from each other in a sixth direction D6. The supporter holes 150_H may be aligned at distances from each other in a seventh direction D7. A distance between supporter holes 150_H adjacent in the sixth direction D6 may be the same as a distance between supporter holes 150_H adjacent in the seventh direction D7. In other words, the supporter holes 150_H may be disposed at equal intervals in each of the sixth and seventh directions D6 and D7. A distance between supporter holes 150_H adjacent in the sixth direction D6 may be less than a distance between supporter holes 150_H adjacent in the second direction D2.

The sixth direction D6 may be a direction between the first direction D1 and the third direction D3. The seventh direction D7 may cross the sixth direction D6. In some examples, an angle formed between the sixth direction D6 and the seventh direction D7 may be greater than 90 degrees. However, the present disclosure is not limited thereto. For example, the angle formed between the sixth direction D6 and the seventh direction D7 may be 90 degrees or less.

The supporter holes 150_H may be symmetrically arranged. For example, the supporter holes 150_H may be symmetrically arranged with respect to a virtual line extending in the first direction D1, and may be symmetrically arranged with respect to the virtual line extending in the second direction D2. In some examples, the supporter holes 150_H may be symmetrically arranged with respect to the virtual line extending in the sixth direction D6, and may be symmetrically arranged with respect to the virtual line extending in the seventh direction D7. The supporter holes 150_H may be arranged in a checkerboard structure or a grid structure in which a unit grid has a rhombus shape. In some examples, the supporter holes 150_H may be arranged in a checkerboard structure rotated at a certain angle.

The lower electrode 130 may include a first lower electrode 132 overlapped/exposed by (e.g., adjacent to, such that it is on a perimeter of) the supporter hole 150_H and a second lower electrode 134 not overlapped/exposed by (e.g., is spaced apart from the perimeter of) the supporter hole 150_H. The first lower electrode 132 may be defined as the lower electrode 130 that is at least partially overlapped/exposed by the supporter hole 150_H, and the second lower electrode 134 may be defined as the lower electrode 130 that is surrounded by the first supporter 150 from a two-dimensional perspective.

The first lower electrode 132 may include first to fourth sub-lower electrodes 132_1, 132_2, 132_3, and 132_4. The first to fourth sub-lower electrodes 132_1, 132_2, 132_3, and 132_4 may refer to the first lower electrodes 132, of a plurality of first lower electrodes 132, that are overlapped/exposed by one supporter hole 150_H. The first to fourth sub-lower electrodes 132_1, 132_2, 132_3, and 132_4 may be the lower electrodes 130 adjacent to each other.

The first sub-lower electrode 132_1 and the second sub-lower electrode 132_2 may be spaced away from each other by a first distance W1 in the first direction D1. The third sub-lower electrode 132_3 may be spaced away from the fourth sub-lower electrode 132_4 by a second distance W2 in the second direction D2. The first distance W1 may be less than the second distance W2. The distance between the lower electrodes 130 may be a distance measured based on the centers of the lower electrodes 130. For convenience of description, based on the center of the supporter hole 150_H, the first sub-lower electrode 132_1 may refer to the first lower electrode 132 disposed on the right side, the second sub-lower electrode 132_2 may refer to the first lower electrode 132 disposed on the left side, the third sub-lower electrode 132_3 may refer to the first lower electrode 132 disposed on the upper side, and the fourth sub-lower electrode 132_4 may refer to the first lower electrode 132 disposed on the lower side.

In a plan view, the supporter hole 150_H may be surrounded by the second lower electrodes 134. In other words, the first to fourth sub-lower electrodes 132_1, 132_2, 132_3, and 132_4 may be surrounded by the second lower electrodes 134.

At least one second lower electrode 134 may be disposed between adjacent supporter holes 150_H. In other words, at least one second lower electrode 134 may be disposed between a group of first to fourth sub-lower electrodes 132_1, 132_2, 132_3, and 132_4 and another group of first to fourth sub-lower electrodes 132_1, 132_2, 132_3, and 132_4.

The first lower electrode 132 and the second lower electrode 134 may be disposed between supporter holes 150_H adjacent in the first direction D1. For example, two first lower electrodes 132 and six second lower electrodes 134 may be disposed between the supporter holes 150_H adjacent in the first direction D1. Specifically, one first lower electrode 132 and two second lower electrodes 134 may be disposed between the third sub-lower electrodes 132_3 adjacent to each other in the first direction D1. Two second lower electrodes 134 may be disposed between the first sub-lower electrode 132_1 overlapped/exposed by one supporter hole 150_H and the second sub-lower electrode 132_2 overlapped/exposed by another supporter hole 150_H adjacent in the first direction D1. One first lower electrode 132 and two second lower electrodes 134 may be disposed between the fourth sub-lower electrodes 132_4 adjacent to each other in the first direction D1.

The second lower electrode 134 may be disposed between two supporter holes 150_H adjacent in the second direction D2, and a first lower electrode 132 adjacent to another supporter hole 150_H than these two support holes 150_H may not be disposed therebetween. Specifically, two second lower electrodes 134 may be disposed between the third sub-lower electrode 132_3 overlapped/exposed by one supporter hole 150_H and the fourth sub-lower electrode 132_4 overlapped/exposed by another supporter hole 150_H adjacent in the second direction D2, and another first lower electrode 132 may not be disposed therebetween.

At least one second lower electrode 134 may be between supporter holes 150_H adjacent in the sixth direction D6. At least one second lower electrode 134 may be disposed between supporter holes 150_H adjacent in the seventh direction D7. For example, virtual lines connecting the centers of each of the supporter holes 150_H may extend in the sixth and seventh directions D6 and D7. The centers of the supporter hole 150_H and the second lower electrodes 134 may be alternately disposed on the virtual lines.

The plurality of lower electrodes 130 may be aligned at regular intervals in the first direction D1. The lower electrodes 130 may be arranged such that the first lower electrodes 132 and the second lower electrodes 134 may be alternately arranged one by one or alternately arranged two by two in the first direction D1. For example, based on the third or fourth sub-lower electrode 132_3 or 132_4 overlapped/exposed by one supporter hole 150_H, the second lower electrodes 134 and the first lower electrodes 132 may be alternately arranged one by one in the first direction D1. In addition, based on the first sub-lower electrode 132_1 overlapped/exposed by one supporter hole 150_H, the second lower electrode 134 and the first lower electrode 132 may be alternately arranged two by two in the first direction D1.

The plurality of lower electrodes 130 may be aligned at regular intervals in the third and fourth directions D3 and D4. The lower electrodes may be alternately arranged such that the number of first lower electrodes 132 and the second lower electrodes 134 may be in the order of 2, 1, 2, and 3 in the third direction D3. For example, based on the first sub-lower electrode 132_1 overlapped/exposed by one supporter hole 150_H, the number of the second lower electrodes 134 and the first lower electrodes 132 may alternate in the order of 1, 2, 3, and 2 in the third direction D3. In addition, based on the third sub-lower electrode 132_3 overlapped/exposed by one supporter hole 150_H, the number of the second lower electrodes 134 and the first lower electrodes 132 may alternate in the order of 3, 2, 1, and 2 in the third direction D3 and the fourth direction D4.

In some examples, the first lower electrodes 130 overlapped/exposed by the supporter holes 150_H may not have constant areas. For example, an area/region R1 of the first sub-lower electrode 132_1 overlapped/exposed by the supporter hole 150_H may be different from an area/region R2 of the third sub-lower electrode 132_3 overlapped/exposed by the supporter hole 150_H. The area/region R1 of the first sub-lower electrode 132_1 overlapped/exposed by the supporter hole 150_H may be greater than the area/region R2 of the third sub-lower electrode 132_3 overlapped/exposed by the supporter hole 150_H. As an example, a larger portion of the first sub-lower electrode 132_1 (e.g., a portion of a perimeter, such as a circumference, thereof) than of the third sub-lower electrode 132_3 may be in the supporter hole 150_H. The first sub-lower electrode 132_1 and the third sub-lower electrode 132_3 may thus have different-sized portions in the supporter hole 150_H. However, the present disclosure is not limited thereto. The area/region R1 of the first sub-lower electrode 132_1 and the area/region R2 of the third sub-lower electrode 132_3 may be the area/region of the sidewall of each of the first and third sub-lower electrodes 132_1, 132_3 overlapped/exposed by the supporter hole 150_H.

In some examples, the area/region R1 of the first sub-lower electrode 132_1 overlapped/exposed by the supporter hole 150_H may be the same as an area/region of the second sub-lower electrode 132_2 overlapped/exposed by the supporter hole 150_H. The area/region R2 of the third sub-lower electrode 132_3 overlapped/exposed by the supporter hole 150_H may be the same as an area/region of the fourth sub-lower electrode 132_4 overlapped/exposed by the supporter hole 150_H. However, the present disclosure is not limited thereto.

The sidewall of the supporter hole 150_H may have a convex shape. The sidewall of the supporter hole 150_H may refer to a portion connected between the first lower electrodes 132. In addition, the sidewall of the supporter hole 150_H may refer to an interface with the supporter 150 based on the supporter hole 150_H, and may be a term corresponding to the sidewall of the supporter 150. For example, the sidewall of the supporter hole 150_H connecting the first sub-lower electrode 132_1 and the third sub-lower electrode 132_3 may have a convex shape. In other words, the sidewall of the supporter 150 connecting the first sub-lower electrode 132_1 and the third sub-lower electrode 132_3 may have a concave shape.

The plurality of supporter holes 150_H may be repeatedly arranged. For example, a unit region Q1 illustrated in FIG. 1 may be repeatedly arranged in the first direction D1 and the second direction D2. The unit region Q1 may be defined as a region including the repeating arrangement of the first lower electrodes 132 and the second lower electrodes 134.

In a semiconductor memory device according to some embodiments, a ratio of the number of the first lower electrodes 132 to the number of the second lower electrodes 134 may be 1:1. In other words, the number of the first lower electrodes 132 and the number of the second lower electrodes 134 may be the same as each other. In the present disclosure, comparing the number of the first lower electrodes 132 with the number of the second lower electrodes 134 may refer to comparing them within the unit region Q1. For example, the number of the first lower electrodes 132 may be 8, and the number of the second lower electrodes 134 may also be 8 in the unit region Q1.

As described above, the plurality of supporter holes 150_H may be repeatedly arranged. Accordingly, the plurality of first lower electrodes 132 and the plurality of second lower electrodes 134 may be repeatedly arranged according to a certain rule. The plurality of first lower electrodes 132 and the plurality of second lower electrodes 134 may be arranged symmetrically. The positions of the first lower electrodes 132 and the positions of the second lower electrodes 134 may be uniformly disposed as a whole. In other words, the first lower electrodes 132 or the second lower electrodes 134 may not be densely arranged in a specific area or a specific line. As a result, the performance of the capacitor structure C_ST can be uniformly maintained, and reliability of the semiconductor memory device can be improved.

Referring back to FIG. 2, the dielectric film 160 may be disposed on the lower electrodes 130, the first supporters 150, and the second supporters 152. The dielectric film 160 may be disposed on portions of the lower electrode 130, which are exposed (e.g., not overlapped in the direction D1) by the first supporter 150 and the second supporter 152. The dielectric film 160 may extend along the profile of the lower electrode 130. For example, the dielectric film 160 may extend along the side surface of the lower electrode 130 overlapped/exposed by the supporter hole 150_H. The dielectric film 160 may be disposed on the upper and lower surfaces of the first supporter 150 and the upper and lower surfaces of the second supporter 152.

For example, the dielectric film 160 may include a high dielectric constant material including silicon oxide, silicon nitride, silicon oxynitride, and a metal. Although it is illustrated that the dielectric film 160 is a single-layered film, it is only for convenience of description, and the present disclosure is not limited thereto. Unlike the illustration, the dielectric film 160 may include a plurality of films.

The conductive film 170 may be disposed on the dielectric film 160. The conductive film 170 may extend along the profile of the dielectric film 160. The conductive film 170 may cover the dielectric film 160. The dielectric film 160 may be disposed between the lower electrode 130 and the conductive film 170.

For example, the conductive film 170 may include at least one of a doped semiconductor material, a conductive metal nitride (e.g., titanium nitride, tantalum nitride, niobium nitride, tungsten nitride, etc.), a metal (e.g., ruthenium, iridium, titanium, tantalum, etc.), and a conductive metal oxide (e.g., iridium oxide or niobium oxide, etc.), although the present disclosure is not limited thereto.

The upper electrode 180 may be disposed on the conductive film 170. The upper electrode 180 may be in (e.g., may fill) an empty space between the lower electrodes 130. The upper electrode 180 may be electrically connected to the conductive film 170. For example, the upper electrode 180 may include at least one of an element semiconductor material film and a compound semiconductor material film. The upper electrode 180 may include a doped n-type impurity or a p-type impurity.

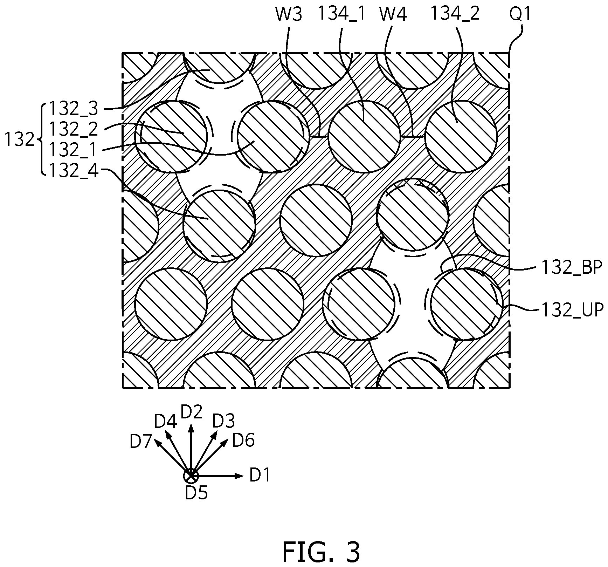

FIG. 3 is a plan view provided to explain a semiconductor memory device according to some embodiments of the present disclosure. For reference, FIG. 3 is an enlarged diagram of the region Q1 of FIG. 1. For convenience of description, differences in configurations from those described in FIGS. 1 and 2 will be mainly described.

Referring to FIGS. 1 to 3, each of the plurality of first lower electrodes 132 may be bent in a predetermined direction in the semiconductor memory device according to some embodiments of the present disclosure. For example, an upper portion 132_UP of the first lower electrode 132 may be bent in a predetermined direction. Unlike the upper portion 132_UP, a lower part 132_BP of the first lower electrode 132 may not be bent and may be spaced apart from the adjacent lower electrode 130 by a predetermined distance.

Specifically, each of the first sub-lower electrode 132_1, the second sub-lower electrode 132_2, the third sub-lower electrode 132_3, and the fourth sub-lower electrode 132_4 may be bent (e.g., tilted) in a direction away from the center of the supporter hole 150_H. Compared with FIG. 1, the first sub-lower electrode 132_1 may be bent to the right, the second sub-lower electrode 132_2 may be bent to the left, the third sub-lower electrode 132_3 may be bent to the upper side, and the fourth sub-lower electrode 132_4 may be bent to the lower side.

The second lower electrode 134 may include a fifth sub-lower electrode 134_1 and a sixth sub-lower electrode 134_2. The fifth sub-lower electrode 134_1 may be the lower electrode 130 adjacent to the first sub-lower electrode 132_1 in the first direction D1, and the sixth sub-lower electrode 134_2 may be the lower electrode 130 adjacent to the fifth sub-lower electrode 134_1 in the first direction D1.

The first sub-lower electrode 132_1 is bent to the right, and accordingly, the distance between the first sub-lower electrode 132_1 and the adjacent second lower electrode 134 may be reduced. For example, based on the first direction D1, a distance W3 from the first sub-lower electrode 132_1 to the fifth sub-lower electrode 134_1 may be less than a distance W4 from the fifth sub-lower electrode 134_1 to the sixth sub-lower electrode 134_2. The distance between the lower electrodes 130 may be the closest distance between the lower electrodes 130.

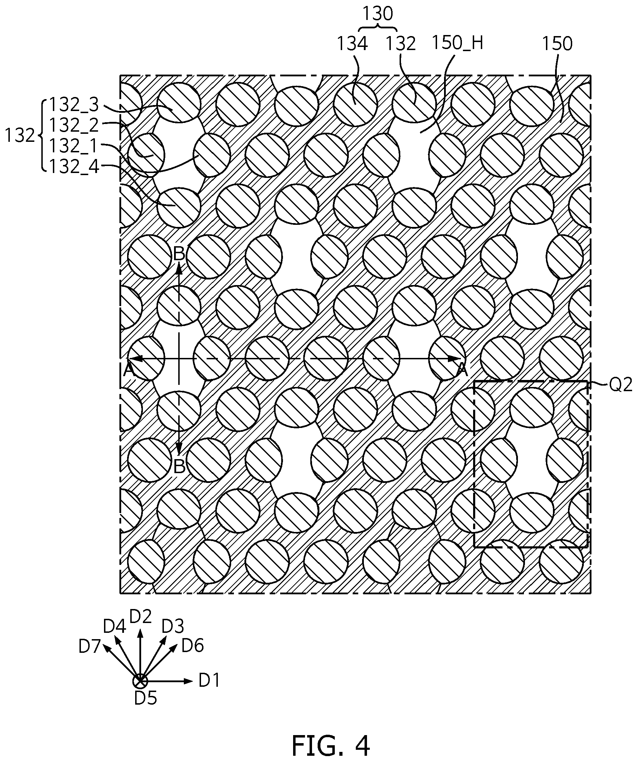

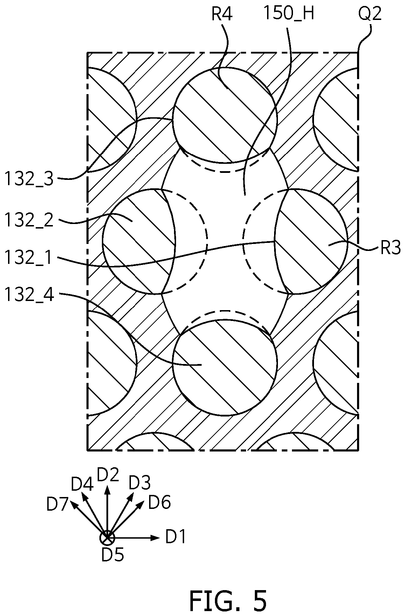

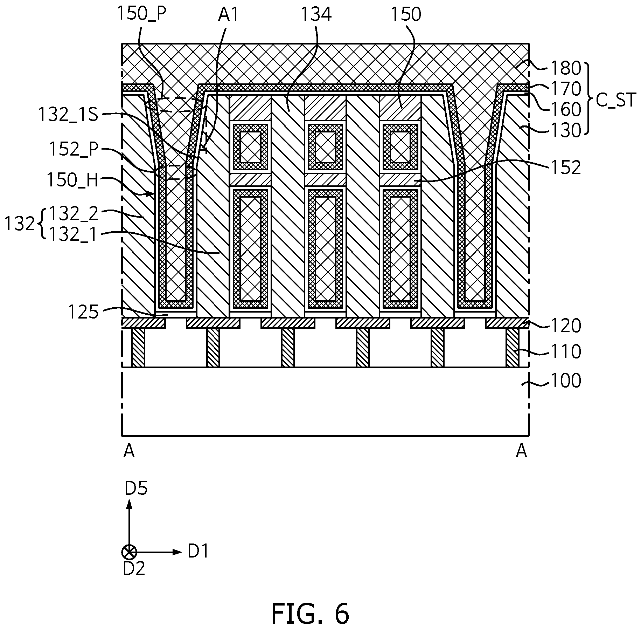

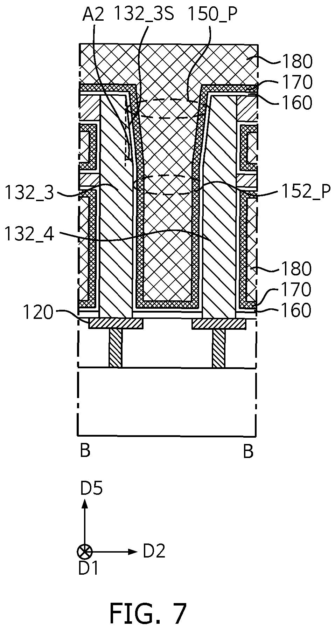

FIGS. 4 to 7 are diagrams provided to explain a semiconductor memory device according to some embodiments of the present disclosure. For convenience of description, differences in configurations from those described in FIGS. 1 and 2 will be mainly described. For reference, FIG. 5 is an enlarged diagram of a region Q2 of FIG. 4. FIG. 6 is a cross-sectional view taken along line A-A of FIG. 4. FIG. 7 is a cross-sectional view taken along line B-B of FIG. 4.

Referring to FIGS. 4 and 5, in the semiconductor memory device according to some embodiments, an area/region R3 of the upper surface of the first sub-lower electrode 132_1 may be different from an area/region R4 of the upper surface of the third sub-lower electrode 132_3. For example, the area/region R3 of the upper surface of the first sub-lower electrode 132_1 may be less (i.e., smaller) than the area/region R4 of the upper surface of the third sub-lower electrode.

At least two of the areas/regions of the first to fourth sub-lower electrodes 132_1, 132_2, 132_3, and 132_4 overlapped/exposed by the supporter hole 150 H may be different from each other. The area/region of the first sub-lower electrode 132_1 overlapped/exposed by the supporter hole 150_H may be greater than the area/region of the third sub-lower electrode 132_3 overlapped/exposed by the supporter hole 150_H. The area/region of the first sub-lower electrode 132_1 overlapped/exposed by the supporter hole 150_H may be the same as the area/region of the second sub-lower electrode 132_2 overlapped/exposed by the supporter hole 150_H. The area/region of the third sub-lower electrode 132_3 overlapped/exposed by the supporter hole 150_H may be the same as the area/region of the fourth sub-lower electrode 132_4 overlapped/exposed by the supporter hole 150_H. However, the present disclosure is not limited thereto. For example, the area/region of the first sub-lower electrode 132_1 overlapped/exposed by the supporter hole 150_H may be different from the area/region of the second sub-lower electrode 132_2 overlapped/exposed by the supporter hole 150_H, and the area/region of the third sub-lower electrode 132_3 overlapped/exposed by the supporter hole 150_H may be different from the area/region of the fourth sub-lower electrode 132_4 overlapped/exposed by the supporter hole 150_H.

Referring to FIGS. 6 and 7, in the semiconductor memory device according to some embodiments, each of the first to fourth sub-lower electrodes 132_1, 132_2, 132_3, and 132_4 may include a chamfered portion on an upper side.

The chamfered portion of the first sub-lower electrode 132_1 may include a first side surface 132_1S. The first side surface 132_1S may have a first slope A1 with respect to an extension line perpendicular to the upper surface of the landing pad 120. The chamfered portion of the third sub-lower electrode 132_3 may include a second side surface 132_3S. The second side surface 132_3S may have a second slope A2 with respect to an extension line perpendicular to the upper surface of the landing pad 120. The first slope A1 may be greater than the second slope A2.

The semiconductor memory device according to some embodiments may further include a first through pattern 150 _P and a second through pattern 152_P. Each of the first through pattern 150_P and the second through pattern 152_P may be disposed on/in the supporter hole 150_H. The first through pattern 150_P may be defined as a region of the supporter hole 150_H which overlaps the first supporter 150 in the first direction D1. The second through pattern 152_P may be defined as a region of the supporter hole 150_H which overlaps the second supporter 152 in the first direction D1.

A width of the first through pattern 150_P in the first direction D1 may be less than a width thereof in the second direction D2. The widths of the first through pattern 150_P in the first and second directions D1 and D2 may increase as the distance from the substrate 100 increases. The width of the first through pattern 150_P in the first direction D1 may be greater than the width of the second through pattern 152_P in the first direction D1. The width of the first through pattern 150_P in the second direction D2 may be greater than the width of the second through pattern 152_P in the second direction D2.

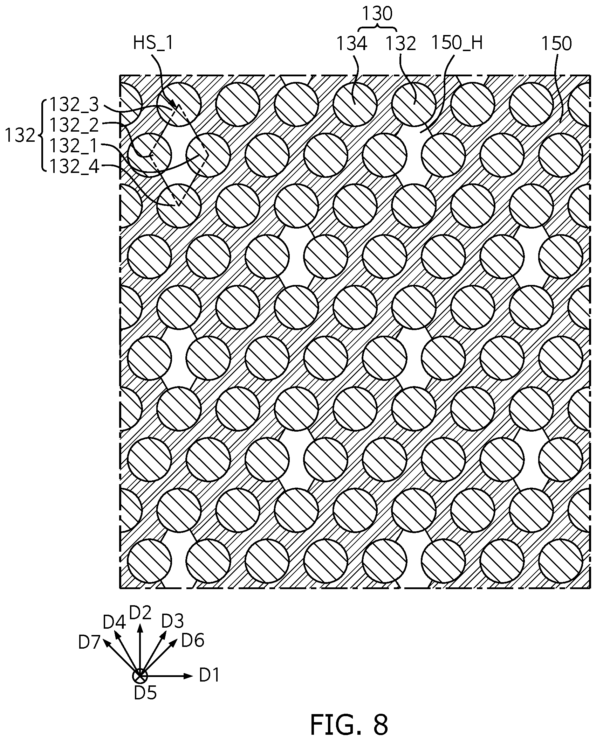

FIG. 8 is a plan view provided to explain a semiconductor memory device according to some embodiments of the present disclosure. For convenience of description, differences in configurations from those described in FIGS. 1 and 2 will be mainly described.

Referring to FIG. 8, the supporter hole 150_H may be disposed on/in a first rectangular pattern HS_1 in the semiconductor memory device according to some embodiments. The first rectangular pattern HS_1 may have a virtual shape formed by extending the sidewall of the supporter hole 150_H. The sidewall of the supporter hole 150_H may refer to a portion connected between the first lower electrodes 132. In addition, the sidewall of the supporter hole 150_H may refer to an interface with the supporter 150 based on the supporter hole 150_H, and may be a term corresponding to the sidewall of the supporter 150. For example, the sidewall of the supporter hole 150_H may refer to a portion connecting the first sub-lower electrode 132_1 and the third sub-lower electrode 132_3. From a two-dimensional perspective, the sidewall of the supporter hole 150_H may have a shape of a straight line.

The vertices of the first rectangular pattern HS_1 may be disposed on the first to fourth sub-lower electrodes 132_1, 132_2, 132_3, and 132_4, respectively. The first rectangular pattern HS_1 may have a rhombus shape. In some examples, each vertex of the first rectangular pattern HS_1 may be disposed at the center of each of the first to fourth sub-lower electrodes 132_1, 132_2, 132_3, and 132_4. However, the present disclosure is not limited thereto.

In some examples, a portion of the sidewall of the supporter hole 150_H may be parallel to an imaginary straight line extending in the third direction D3. The other portion of the supporter hole 150_H may be parallel to an imaginary straight line extending in the fourth direction D4. However, the present disclosure is not limited thereto.

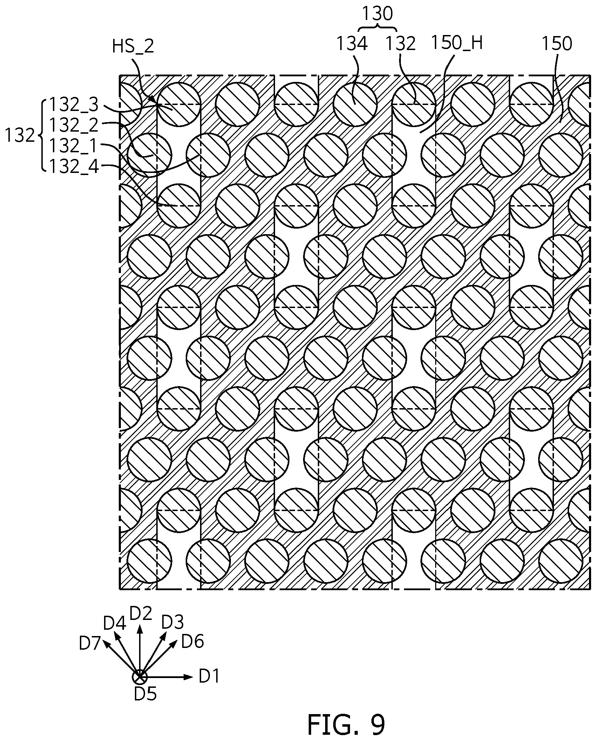

FIG. 9 is a plan view provided to explain a semiconductor memory device according to some embodiments of the present disclosure. For convenience of description, difference configurations from those described in FIGS. 1 and 2 will be mainly described.

Referring to FIG. 9, the supporter hole 150_H may be disposed on/in a first rectangular pattern HS_2 in the semiconductor memory device according to some embodiments. The second rectangular pattern HS_2 may have a virtual shape formed by extending the sidewall of the supporter hole 150_H. The sidewall of the supporter hole 150_H may refer to a portion connected between the first lower electrodes 132. In addition, the sidewall of the supporter hole 150_H may refer to an interface with the supporter 150 based on the supporter hole 150_H, and may be a term corresponding to the sidewall of the supporter 150. For example, the sidewall of the supporter hole 150_H may refer to a portion connecting the first sub-lower electrode 132_1 and the third sub-lower electrode 132_3. From a two-dimensional perspective, the sidewall of the supporter hole 150_H may have a shape of a straight line.

Each vertex of the second rectangular pattern HS_2 may be disposed on the third sub-lower electrode 132_3 and the fourth sub-lower electrode 132_4, respectively. For example, two vertices of the second rectangular pattern HS_2 may be disposed on the sidewall of the third sub-lower electrode 132_3. The other two vertices of the second rectangular pattern HS_2 may be disposed on the sidewall of the fourth sub-lower electrode 132_4. The second rectangular pattern HS_2 may have a rectangular shape having longer sides in the second direction D2.

In some examples, a portion of the sidewall of the supporter hole 150_H may be parallel to an imaginary straight line extending in the first direction D1. The other portion of the supporter hole 150_H may be parallel to an imaginary straight line extending in the second direction D2. However, the present disclosure is not limited thereto.

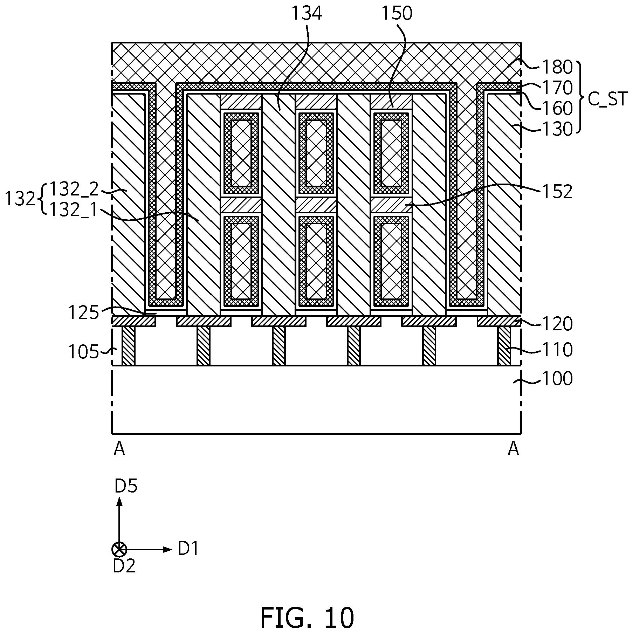

FIG. 10 is a diagram provided to explain a semiconductor memory device according to some embodiments of the present disclosure. For reference, FIG. 10 may correspond to a cross-sectional view taken along line A-A of FIG. 1. For convenience of description, differences in configurations from those described in FIGS. 1 and 2 will be mainly described.

Referring to FIG. 10, the semiconductor memory device according to some embodiments may include the first supporter 150 and the second supporter 152.

The first supporter 150 and the second supporter 152 may be disposed between the plurality of lower electrodes 130. The first supporter 150 and the second supporter 152 may be disposed between adjacent lower electrodes 130. The first supporter 150 and the second supporter 152 may connect and support the adjacent lower electrodes 130.

The first supporter 150 may have a first thickness in the fifth direction D5. The second supporter 152 may have a second thickness in the fifth direction D5. The first thickness and the second thickness may be the same as each other.

In some examples, based on the fifth direction D5, the distance between the first supporter 150 and the second supporter 152 may be the same as the distance between the second supporter 152 and the etching stop film 125. However, the present disclosure is not limited thereto.

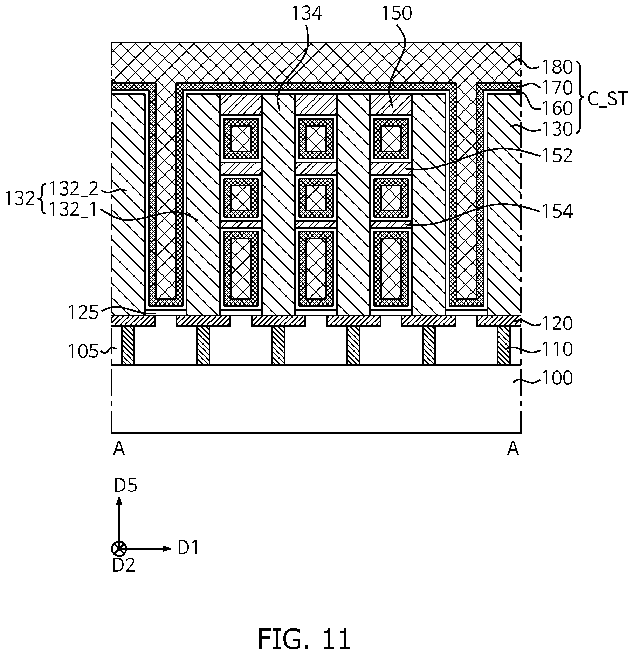

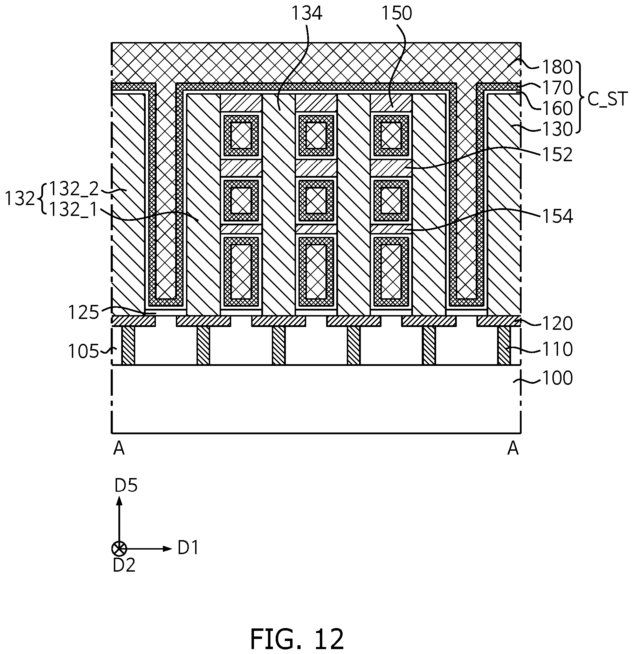

FIG. 11 is a diagram provided to explain a semiconductor memory device according to some embodiments of the present disclosure. FIG. 12 is a diagram provided to explain a semiconductor memory device according to some embodiments of the present disclosure. For reference, each of FIGS. 11 and 12 may correspond to a cross-sectional view taken along line A-A of FIG. 1. For convenience of description, differences in configurations from those described in FIGS. 1 and 2 will be mainly described.

Referring to FIGS. 11 and 12, the semiconductor memory device according to some embodiments may further include a third supporter 154.

100. The first to third supporters 150, 152, and 154 may be disposed between the plurality of lower electrodes 130. The first to third supporters 150, 152, and 154 may be disposed between adjacent lower electrodes 130. The first to third supporters 150, 152, and 154 may connect and support the adjacent lower electrodes 130.

The first to third supporters 150, 152, and 154 may be sequentially disposed on the etching stop film 125. For example, with respect to the upper surface of the landing pad 120, the first supporter 150 may be disposed highest, and the second supporter 152 and the third supporter 154 may follow in order.

The first supporter 150 may be disposed on the second supporter 152. The first supporter 150 may be spaced apart from the second supporter 152 in the fifth direction D5. The second supporter 152 may be disposed on the third supporter 154. The second supporter 152 may be spaced apart from the third supporter 154 in the fifth direction D5. The third supporter 154 may be spaced apart from the etching stop film 125 in the fifth direction D5.

As illustrated in FIG. 11, in some examples, the thickness of the first supporter 150 may be greater than the thickness of the second supporter 152, and the thickness of the second supporter 152 may be greater than the thickness of the third supporter 154. The thickness may refer to a thickness in the fifth direction D5. However, the present disclosure is not limited thereto.

As illustrated in FIG. 12, in some examples, the thickness of the first supporter 150 may be the same as the thickness of the second supporter 152. The thicknesses of the first supporter 150 and the second supporter 152 may be greater than the thickness of the third supporter 154. However, the present disclosure is not limited thereto. Although not illustrated, the thicknesses of the first to third supporters 150, 152, and 154 may be the same as each other.

The dielectric film 160, the conductive film 170, and the upper electrode 180 may be disposed between the first supporter 150 and the second supporter 152, between the second supporter 152 and the third supporter 154, and between the third supporter 154 and the etching stop film 125, respectively.

In some examples, the distance between the first supporter 150 and the second supporter 152 spaced apart from each other may be the same as the distance between the second supporter 152 and the third supporter 154 spaced apart from each other.

In some examples, the distance between the first supporter 150 and the second supporter 152 spaced apart from each other may be different from the distance between the second supporter 152 and the third supporter 154 spaced apart from each other. For example, the distance between the first supporter 150 and the second supporter 152 spaced apart from each other may be less than the distance between the second supporter 152 and the third supporter 154 spaced apart from each other. The distance between the second supporter 152 and the third supporter 154 spaced apart from each other may be less than the distance between the third supporter 154 and the etching stop film 125 spaced apart from each other. However, the present disclosure is not limited thereto.

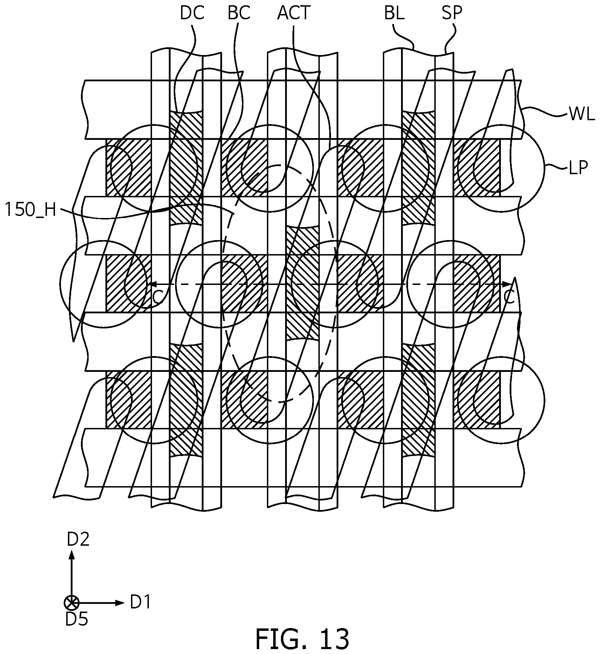

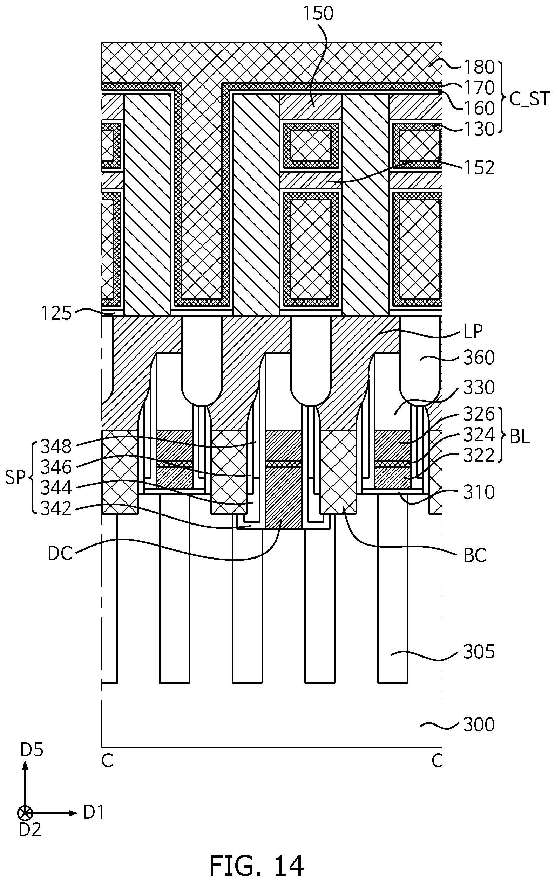

FIGS. 13 and 14 are diagrams provided to explain a semiconductor memory device according to some embodiments of the present disclosure. For reference, FIG. 13 is a schematic layout diagram provided to explain a semiconductor memory device according to some embodiments. FIG. 14 is a cross-sectional view taken along line C-C of FIG. 13.

Referring to FIGS. 13 and 14, the semiconductor memory device according to some embodiments may include a plurality of active regions ACT. The active region ACT may be defined by a device isolation film 305 formed in a substrate 300. The active region ACT may have a bar shape. The plurality of active regions ACT may be spaced apart from each other. The device isolation film 305 may have a shallow trench isolation (STI) structure having excellent device isolation characteristics.

For example, each of a plurality of device isolation films 305 may include at least one of a silicon oxide film, a silicon nitride film, and a silicon oxynitride film, but is not limited thereto. Although it is illustrated that each of the device isolation films 305 is formed of one insulating film, it is only for convenience of description, and the present disclosure is not limited thereto.

A word line WL may cross the active region ACT. The word line WL may extend in the first direction D1. A plurality of word lines WL may be spaced apart from each other in the second direction D2. The plurality of word lines WL may be disposed at equal intervals. A width of the word line WL, or the interval between the word lines WL may be determined according to a design rule.

In some examples, the word line WL may be disposed on a gate trench formed in the substrate 300 and the device isolation film 305. The word line WL may include a gate insulating film, a gate electrode, and a gate capping pattern.

The gate electrode may include at least one of a metal, a metal alloy, a conductive metal nitride, a conductive metal carbon nitride, a conductive metal carbide, a metal silicide, a doped semiconductor material, a conductive metal oxynitride, and a conductive metal oxide.

A plurality of bit lines BL extending in the second direction D2 orthogonal to the word line WL may be disposed on the word line WL. The plurality of bit lines BL may extend parallel to each other. The bit lines BL may be disposed at equal intervals. A width of the bit line BL, or the interval between the bit lines BL may be determined according to a design rule.

The bit line BL may include first to third cell conductive films 322, 324, and 326. The first to third cell conductive films 322, 324, and 326 may be sequentially stacked on the substrate 300 and the device isolation film 305. FIG. 14 illustrates that the bit line BL is a three-layered film, but the present disclosure is not limited thereto.

Each of the first to third cell conductive films 322, 324, and 326 may include at least one of an impurity-doped semiconductor material, a conductive silicide compound, a conductive metal nitride metal, and a metal alloy.

A bit line capping film 330 may be disposed on the bit line BL. The bit line capping film 330 may extend along an upper surface of the third cell conductive film 326. For example, the bit line capping film 330 may include at least one of a silicon nitride film, a silicon oxynitride, a silicon carbon nitride, and a silicon oxycarbonitride. The bit line capping film 330 is illustrated as a single film, but the present disclosure is not limited thereto.

A direct contact DC may be formed between the bit line BL and the substrate 100. The direct contact DC may electrically connect the bit line BL and the substrate 100. The bit line BL may be formed on the direct contact DC. For example, the direct contact DC may be formed at a point where the bit line BL crosses the middle portion of the active region ACT having an elongated island shape.

For example, the direct contact DC may include at least one of an impurity-doped semiconductor material, a conductive silicide compound, a conductive metal nitride, and a metal.

The bit line BL may include the second cell conductive film 324 and the third cell conductive film 326 in a region overlapping an upper surface of the direct contact DC. The bit line BL may include the first to third cell conductive films 322, 324, and 326 in a region not overlapping the upper surface of the direct contact DC.

A cell insulating film 310 may be formed on the substrate 300 and the device isolation film 305. Specifically, the cell insulating film 310 may be formed on the device isolation film 305 and a portion of the substrate 300 on which the direct contact DC is not formed. The cell insulating film 310 may be formed between the substrate 300 and the bit line BL, and between the device isolation film 305 and the bit line BL.

A cell line spacer SP may be disposed on the bit line BL and the sidewall of the bit line capping film 330. The cell line spacer SP may be formed on the substrate 300 and the device isolation film 305 at a portion of the bit line BL on which the direct contact DC is formed. The cell line spacer SP may be disposed on the sidewalls of the bit line BL, the bit line capping film 330, and the direct contact DC.

However, the cell line spacer SP may be disposed on the cell insulating film 310 in the other portion of the bit line BL where the direct contact DC is not formed. The cell line spacer SP may be disposed on the sidewalls of the bit line BL and the bit line capping film 330.

The cell line spacer SP may be a single-layered film, but as illustrated, the cell line spacer SP may be a multi-layered film that includes first to fourth cell line spacers 342, 344, 346, and 348. For example, the first to fourth cell line spacers 342, 344, 346, and 348 may include one of a silicon oxide film, a silicon nitride film, a silicon oxynitride film (SiON), a silicon oxycarbon nitride film (SiOCN), an air gap, and a combination thereof, but are not limited thereto.

A buried contact BC may be disposed between the bit lines BL adjacent in the first direction D1. The buried contact BC may be connected to the active region ACT. The buried contact BC may connect the active region ACT and the capacitor structure C_ST. This structure of arrangement may cause an area of contact between the buried contact BC and the active region ACT to be small. Accordingly, a landing pad LP may be disposed to expand the contact area with the active region ACT and also expand the contact area with the capacitor structure C_ST.

For example, the buried contact BC may include at least one of an impurity-doped semiconductor material, a conductive silicide compound, a conductive metal nitride, and a metal.

The landing pad LP may be formed on the buried contact BC. The landing pad LP may be electrically connected to the buried contact BC. The landing pad LP may be disposed between the active region ACT and the buried contact BC. The landing pad LP may be disposed between the buried contact BC and the lower electrode 130. By expanding the contact area through the landing pad LP, contact resistance between the active region ACT and the lower electrode 130 may be reduced.

For example, the landing pad LP may include at least one of an impurity-doped semiconductor material, a conductive silicide compound, a conductive metal nitride, a conductive metal carbide, a metal, and a metal alloy.

A pad isolation insulating film 360 may be disposed between the landing pads LP. The pad isolation insulating film 360 may electrically separate a plurality of landing pads LPs from each other. For example, the pad isolation insulating film 360 may include at least one of a silicon oxide film, a silicon nitride film, a silicon oxynitride film, a silicon oxycarbon nitride film, and a silicon carbon nitride film.

The etching stop film 125 may be disposed on the upper surface of the landing pad LP and the upper surface of the pad isolation insulating film 360. For example, the etching stop film 125 may include at least one of silicon nitride (SiN), silicon carbon nitride (SiCN), silicon oxycarbonitride (SiOCN), silicon oxynitride (SiOC), and silicon boron nitride (SiBN).

The capacitor structure C_ST may be disposed on the landing pad LP. The capacitor structure C_ST may be connected to the landing pad LP. That is, the capacitor structure C_ST may be electrically connected to the buried contact BC.

The capacitor structure C_ST may include the lower electrode 130, the dielectric film 160, the conductive film 170, and the upper electrode 180. The first supporter 150 and the second supporter 152 may be disposed between the lower electrodes 130. Descriptions of the capacitor structure C_ST, the first supporter 150, and the second supporter 152 may be the same as those described above with reference to FIGS. 1 to 12.

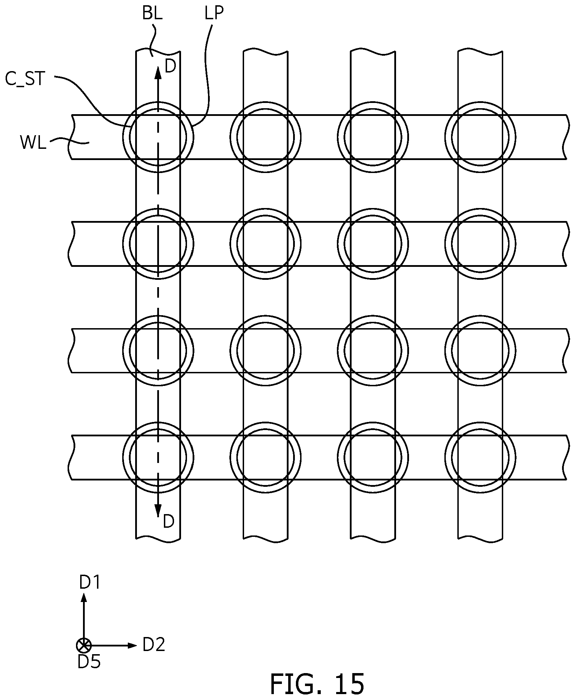

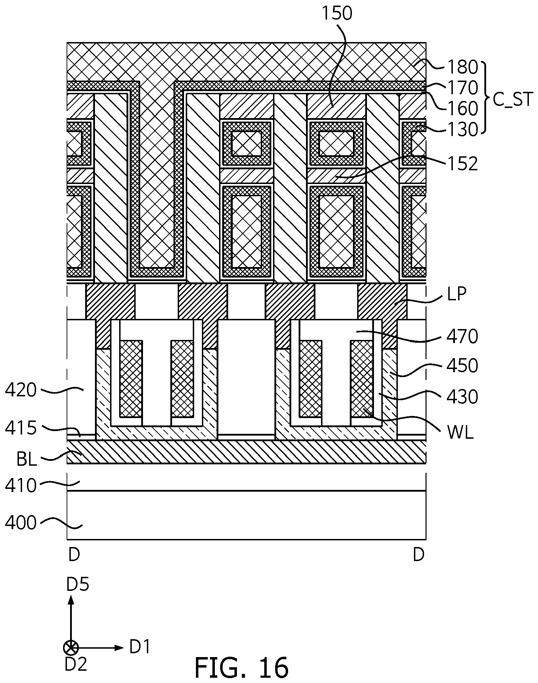

FIGS. 15 and 16 are diagrams provided to explain a semiconductor memory device according to some embodiments of the present disclosure. For reference, FIG. 16 is a cross-sectional view taken along line D-D of FIG. 15.

Referring to FIGS. 15 and 16, the semiconductor memory device according to some embodiments may include a substrate 400, a lower insulating film 410, a bit line BL, a word line WL, a gate insulating film 430, a channel layer 450, a landing pad LP, and a capacitor structure C_ST. The semiconductor memory device according to some embodiments may be a memory device including a vertical channel transistor VCT. The vertical channel transistor may refer to a structure in which the channel length of the channel layer 450 extends in the fifth direction D5 that is perpendicular to the substrate 400.

The lower insulating film 410 may be disposed on the substrate 400. A plurality of bit lines BL may be disposed on the lower insulating film 410. The plurality of bit lines BL may extend in the first direction D1. The plurality of bit lines BL may be spaced apart from each other in the second direction D2.

The plurality of bit lines BL may include a doped semiconductor material, a metal, a metal alloy, a conductive metal nitride, a conductive metal silicide, a conductive metal oxide, or a combination thereof. For example, the plurality of bit lines BL may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrO, RuO, or a combination thereof, but are not limited thereto. The plurality of bit lines BL may include a single layer or multiple layers of the materials mentioned above. In example aspects, the plurality of bit lines BL may include graphene, carbon nanotube, or a combination thereof.

A mold etching stop film 415 may be disposed on the bit line BL. A mold pattern 420 may be disposed on the mold etching stop film 415. The mold etching stop film 415 and the mold pattern 420 may extend in the second direction D2. A plurality of mold patterns 420 may be spaced apart from each other in the first direction D1.

The channel layer 450 may be disposed on the bit line BL. The channel layer 450 may be disposed between the mold patterns 420. The channel layer 450 may include a horizontal portion in contact with the bit line BL and a vertical portion extending from the horizontal portion in the fifth direction D5. The vertical portion may include a first vertical portion disposed at one end of the horizontal portion and a second vertical portion disposed at the other (e.g., opposite) end of the horizontal portion. The first vertical portion and the second vertical portion may be spaced apart from each other in the first direction D1. In some examples, unlike the illustration, the horizontal portion of the channel layer may be separated.

The channel layer 450 may include an oxide semiconductor. For example, the oxide semiconductor may include InGaZnO, InGaSiO, InSnZnO, InZnO, ZnO, ZnSnO, ZnON, ZrZnSnO, SnO, HflnZnO, GaZnSnO, AlZnSnO, YbGaZnO, InGaO, or a combination thereof. The channel layer 450 may include a single layer or multiple layers of an oxide semiconductor. In addition, the channel layer 450 may be polycrystalline or amorphous, for example, but is not limited thereto. In some examples, the channel layer 450 may include graphene, carbon nanotube, or a combination thereof.

The gate insulating film 430 may be disposed on the channel layer 450. The gate insulating film 430 may be disposed between the channel layer 450 and the word line WL. The channel layer 450 and the word line WL may be spaced apart from each other by the gate insulating film 430.

The gate insulating film 430 may include a silicon oxide film, a silicon oxynitride film, a high dielectric constant insulating film having a dielectric constant higher than that of the silicon oxide film, or a combination thereof.

The word line WL may be disposed on the gate insulating film 430. The word line WL may extend in the second direction D2. The word line WL may extend in the fifth direction D5 along the vertical portion of the channel layer 450.

A level of an upper surface of the word line WL may be higher, in the direction D5, than a level of an upper surface of the channel layer 450. Specifically, with respect to the upper surface of the bit line BL, a distance to the upper surface of the word line WL may be greater than a distance to the upper surface of the vertical portion of the channel layer 450. However, the present disclosure is not limited thereto. For example, the upper surface of the word line WL may be disposed on the same plane as, or lower than the upper surface of the channel layer 450.

The word line WL may include a conductive material. For example, the word line WL may include at least one of doped polysilicon, conductive metal nitride, conductive metal silicon nitride, metal carbon nitride, conductive metal silicide, conductive metal oxide, a two-dimensional material, a metal, and a metal alloy.

A gate isolation pattern 470 may be disposed between the word lines WL. The word lines WL may be spaced apart from each other by the gate isolation pattern 470. For example, the word line WL disposed on the first vertical portion and the word line WL disposed on the second vertical portion may be spaced apart from each other in the first direction D1 by the gate isolation pattern 470. The gate isolation pattern 470 may include an insulating material.

The landing pad LP may be disposed on the mold pattern 420 and the gate isolation pattern 470. The landing pad LP may include a protrusion portion protruding toward the channel layer 450. The protrusion portion of the landing pad LP may be in contact with the vertical portion of the channel layer 450. The landing pad LP may be electrically connected to the channel layer 450.

The landing pad LP may include a conductive material. The landing pad LP may include at least one of doped polysilicon, conductive metal nitride, conductive metal silicon nitride, metal carbon nitride, conductive metal silicide, conductive metal oxide, a two-dimensional material, a metal, and a metal alloy.

The capacitor structure C_ST may be disposed on the landing pad LP. The capacitor structure C_ST may be connected to the landing pad LP. That is, the channel layer 450 and the capacitor structure C_ST may be electrically connected to each other through the landing pad LP.

The capacitor structure C_ST may include the lower electrode 130, the dielectric film 160, the conductive film 170, and the upper electrode 180. The first supporter 150 and the second supporter 152 may be disposed between the lower electrodes 130. Descriptions of the capacitor structure C_ST, the first supporter 150, and the second supporter 152 may be the same as those described above with reference to FIGS. 1 to 12.

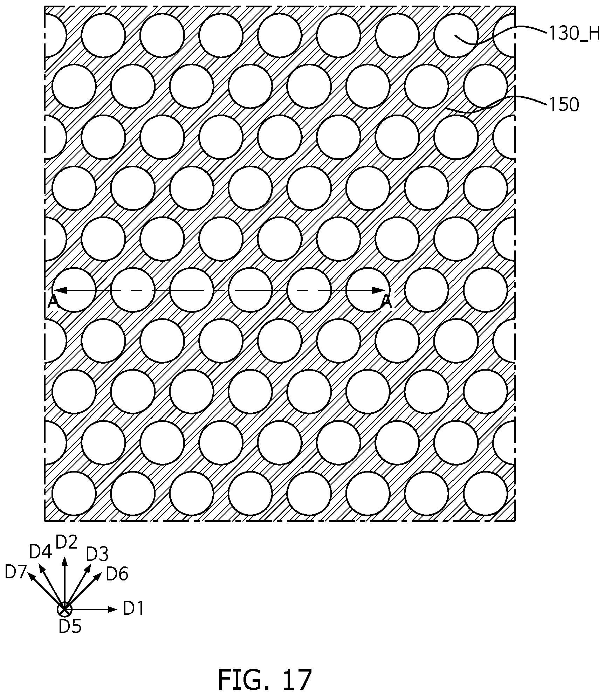

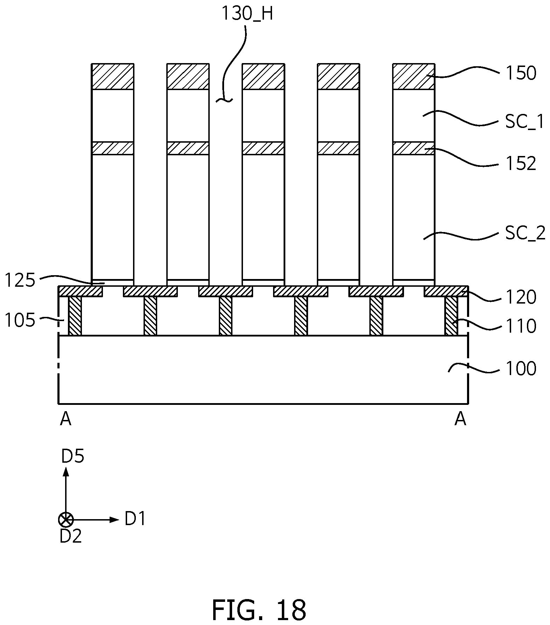

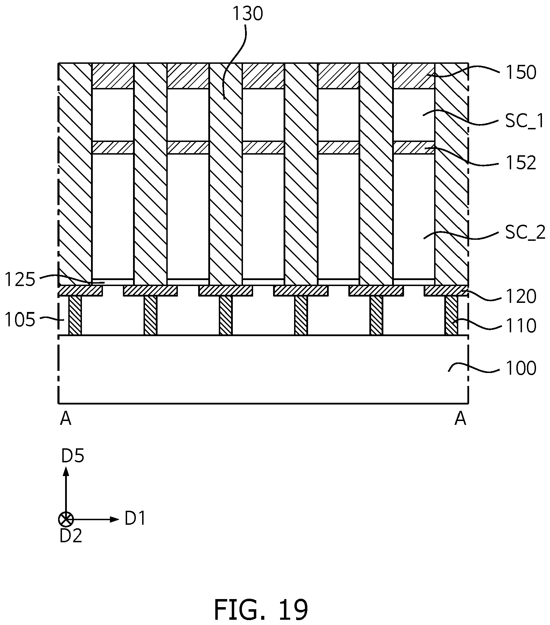

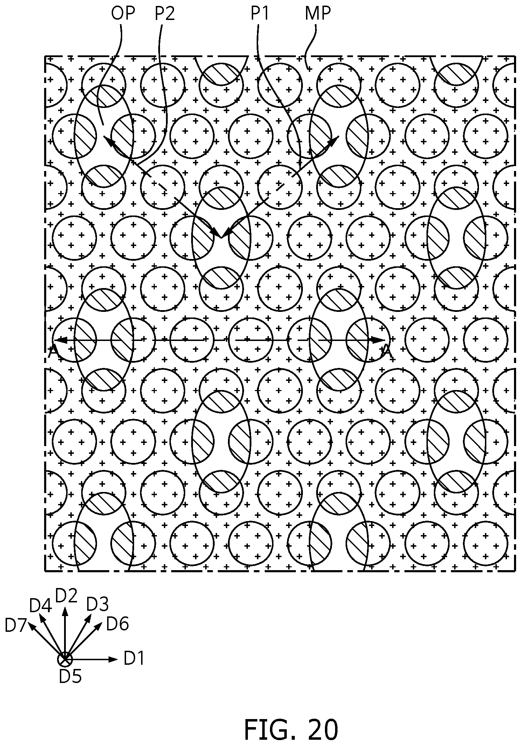

FIGS. 17 to 25 are diagrams showing intermediate stages, provided to explain a method for manufacturing a semiconductor memory device according to some embodiments of the present disclosure. For reference, FIGS. 17 and 20 are plan views showing the intermediate stages. FIGS. 18 and 19 are cross-sectional views taken along line A-A of FIG. 17, and FIGS. 21 to 25 are cross-sectional views taken along line A-A of FIG. 20.

Referring to FIGS. 17 and 18, the contact plug 110, the landing pad 120, and the interlayer insulating film 105 may be formed on the substrate 100. The etching stop film 125, a second sacrificial film SC_2, the second supporter 152, a first sacrificial film SC_1, and the first supporter 150 may be sequentially stacked on the interlayer insulating film 105 and the landing pad 120. The first sacrificial film SC_1 and the second sacrificial film SC_2 may include the same or similar material. For example, the first sacrificial film SC_1 and the second sacrificial film SC_2 may include silicon oxide.

A lower electrode hole 130_H may be formed, extending through the etching stop film 125, the second sacrificial film SC_2, the second supporter 152, the first sacrificial film SC_1, and the first supporter 150. The lower electrode hole 130_H may expose a portion (e.g., a portion of an upper surface) of the landing pad 120. The lower electrode hole 130_H may extend in the fifth direction D5. FIG. 18 illustrates that the width of the lower electrode hole 130_H is constant, but the present disclosure is not limited thereto. For example, the width of the lower electrode hole 130_H may become narrower as it approaches the landing pad 120. In this case, the lower electrode hole 130_H may have a tapered shape.

Referring to FIGS. 18 and 19, the lower electrode 130 may be formed on the landing pad 120. The lower electrode 130 may fill the lower electrode hole 130_H. The lower electrode 130 may be formed by a process such as chemical vapor deposition (CVD), atomic layer deposition (ALD), or plasma enhanced ALD.

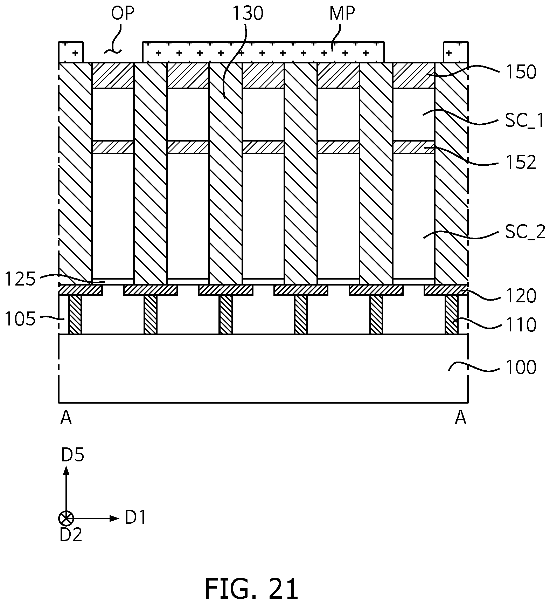

Referring to FIGS. 20 and 21, a mask pattern MP may be formed on the lower electrode 130 and the first supporter 150. The mask pattern MP may include an opening OP. For example, the mask pattern MP may include at least one of a spin-on hardmask (SOH) or an amorphous carbon layer/film (ACL).

The opening OP may expose a portion (e.g., a portion of an upper surface) of the lower electrode 130, and the first supporter 150. The number of the lower electrodes 130 exposed by one opening OP may be four.

The arrangement of the openings OP may correspond to the arrangement of the supporter holes 150_H described above with reference to FIG. 1. For example, the openings OP may be spaced apart from each other at regular intervals in the first direction D1. The openings OP may be spaced apart from each other at regular intervals in the second direction D2. A distance by which the openings OP are spaced apart from each other in the first direction D1 may be greater than a distance by which they are spaced apart from each other in the second direction D2. The openings OP may be spaced apart from each other at equal intervals in the sixth and seventh directions D6 and D7.

As illustrated, the openings OP may be spaced apart from each other by a first pitch P1 in the sixth direction D6. The openings OP may be spaced apart from each other by a second pitch P2 in the seventh direction D7. The first pitch P1 and the second pitch P2 may be the same as each other. The first pitch P1 and the second pitch P2 may be distances measured with respect to the center of the opening OP.

In some examples, the first pitch P1 and the second pitch P2 may be 7.8 F. However, the present disclosure is not limited thereto. The first pitch P1 and the second pitch P2 may be less than 7.8 F. F may refer to a minimum lithographic feature size.

As semiconductor memory devices are becoming increasingly integrated, the size of lithography features is decreasing. Accordingly, there are cases in which extreme ultraviolet lithography (EUV) equipment is required to implement a smaller lithographic feature size. According to a method for manufacturing a semiconductor memory device according to some embodiments of the present disclosure, the distance between the openings OP may be 7.8 F. Accordingly, it is possible to use ArF immersion equipment instead of EUV equipment to form the openings OP of the mask pattern MP according to some embodiments. The ArF immersion equipment may have a longer wavelength than the EUV equipment, but the cost is low, and accordingly, the manufacturing cost of semiconductor memory devices can be decreased.

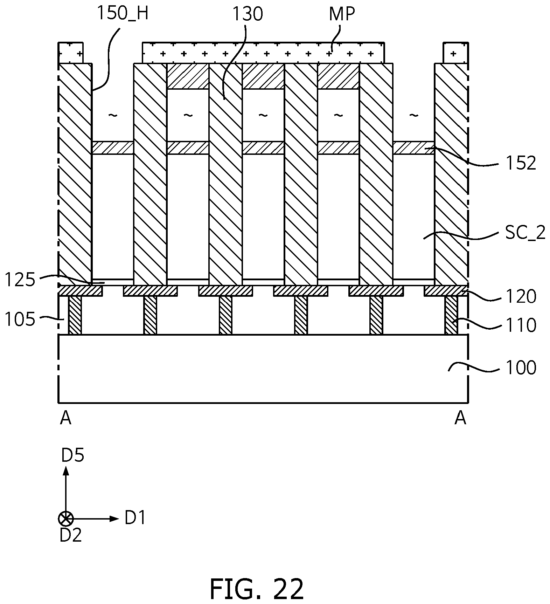

Referring to FIG. 22, the first supporter 150 exposed by the mask pattern MP may be removed, and the first sacrificial film SC_1 may be removed.

Specifically, the first supporter 150 of the plurality of first supporters 150, which is exposed by the mask pattern MP, may be removed by an etching process. For example, the etching process may be a dry etching process. The lower electrode 130 having an etching selectivity with respect to the first supporter 150 may not be removed in the etching process. The first supporter 150 may be removed, and the first sacrificial film SC_1 may be exposed.

The first sacrificial film SC_1 may be removed by the etching process, and the supporter hole 150_H may be formed. For example, the first sacrificial film SC_1 may be removed by a wet etching process. The supporter hole 150_H may expose a portion (e.g., a side surface) of the lower electrode 130 and a portion (e.g., an upper surface) of the second supporter 152.

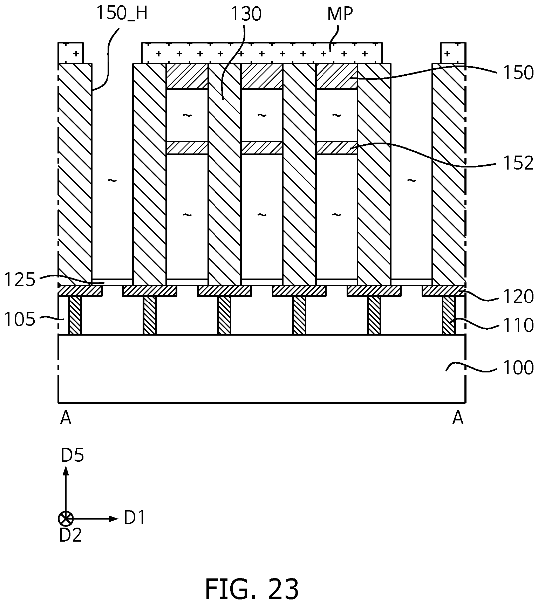

Referring to FIG. 23, the second supporter 152 of a plurality of second supporters 152, which is exposed by the supporter hole 150_H, may be removed by an etching process. For example, the etching process may be a dry etching process. The lower electrode 130 having an etching selectivity with respect to the second supporter 152 may not be removed in the etching process. The second supporter 152 may be removed, and the second sacrificial film SC_2 may be exposed.

The second sacrificial film SC_2 may be removed by the etching process, and the supporter hole 150_H may extend in the fifth direction D5. For example, the second sacrificial film SC_2 may be removed by a wet etching process. A bottom surface of the supporter hole 150_H may expose the etching stop film 125.

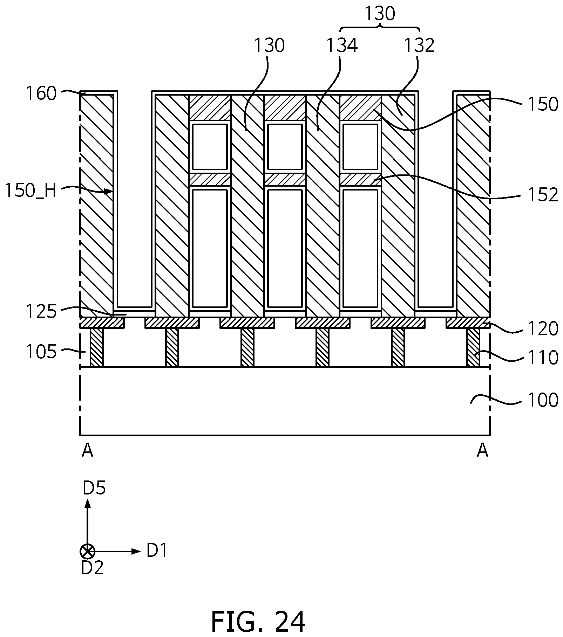

Referring to FIG. 24, the mask pattern MP may be removed, and the dielectric film 160 may be formed on the lower electrode 130, the first supporter 150, and the second supporter 152.

Specifically, the mask pattern MP may be removed, and the upper surface of the lower electrode 130 and the upper surface of the first supporter 150 may be exposed. The lower electrode 130 may include the first lower electrode 132 and the second lower electrode 134. The first lower electrode 132 may refer to the lower electrode 130 of the plurality of lower electrodes 130, which is adjacent to (e.g., on a perimeter of, exposed by) the supporter hole 150_H, and the second lower electrode 134 may refer to the lower electrode 130 of the plurality of lower electrodes 130, which is spaced apart from (e.g., not exposed by) the supporter hole 150_H.

The dielectric film 160 may be formed along the upper surface and the side surface of the first lower electrode 132 and the upper surface of the first supporter 150. In addition, the dielectric film 160 may be formed on the lower surface of the first supporter 150, the upper surface of the second supporter 152, and the lower electrode 130 exposed between the first and second supporters 150 and 152. The dielectric film 160 may be formed on the lower surface of the second supporter 152, the upper surface of the etching stop film 125, and the lower electrode 130 exposed between the second supporter 152 and the etching stop film 125.

For example, the dielectric film 160 may be formed with a method such as chemical vapor deposition (CVD), atomic layer deposition (ALD), PEALD, etc.

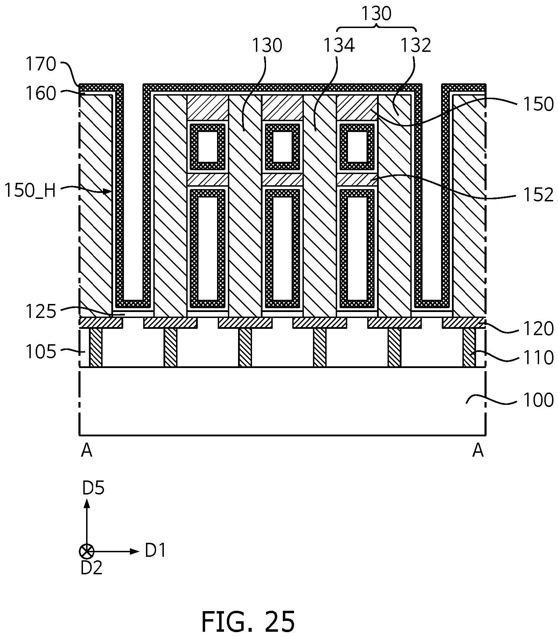

Referring to FIG. 25, the conductive film 170 may be formed on the dielectric film 160. The conductive film 170 may be formed along the profile of the dielectric film 160. For example, the conductive film 170 may be formed along the profile of the dielectric film 160 disposed on the lower electrode 130, the first supporter 150, the second supporter 152, and the etching stop film 125.

The conductive film 170 may be formed with a method such as chemical vapor deposition (CVD), atomic layer deposition (ALD), PEALD, etc.

Referring to FIG. 2, the upper electrode 180 may be formed on the conductive film 170, and the capacitor structure C_ST may be formed.

Although the present disclosure has been described above with respect to embodiments thereof, the present disclosure is not limited thereto. Various modifications and variations can be made thereto by those skilled in the art within the scope of the present disclosure, as defined by the appended claims.

## Claims

1. A semiconductor memory device comprising:
a substrate (100, 300, 400);
a plurality of lower electrodes (130) on the substrate (100, 300, 400); and
a supporter (150) connecting the plurality of lower electrodes (130) to each other,
wherein the supporter (150) includes a plurality of supporter holes (150_H) adjacent to some of the plurality of lower electrodes (130),
wherein the plurality of lower electrodes (130) include a plurality of first lower electrodes (132) adjacent to the plurality of supporter holes (150_H) and a plurality of second lower electrodes (134) spaced apart from the plurality of supporter holes (150_H),
wherein four adjacent first lower electrodes (132_1, 132_2, 132_3, 132_4) of the plurality of first lower electrodes (132) are adjacent to one of the plurality of supporter holes (150_H), and
wherein the plurality of supporter holes (150_H) are at equal intervals in a first direction (D6) and a second direction (D7) crossing the first direction (D6).

2. The semiconductor memory device according to claim 1, wherein each of the plurality of supporter holes (150_H) is surrounded by the plurality of second lower electrodes (134).

3. The semiconductor memory device according to claim 1 or 2, wherein a ratio of a number of the plurality of first lower electrodes (132) to a number of the plurality of second lower electrodes (134) is 1:1.

4. The semiconductor memory device according to any one of claims 1 to 3,
wherein the four adjacent first lower electrodes (132_1, 132_2, 132_3, 132_4) include first to fourth sub-lower electrodes, respectively, that are on a perimeter of the one of the plurality of supporter holes (150_,
wherein the first sub-lower electrode (132_1) is spaced apart from the second sub-lower electrode (132_2) by a first distance (W1) in a third direction (D1),
wherein the third sub-lower electrode (132_3) is spaced apart from the fourth sub-lower electrode (132_4) by a second distance (W2) in a fourth direction (D2) perpendicular to the third direction (D1),
wherein the first to fourth directions (D6, D7, D1, D2) cross each other, and
wherein the first distance (W1) is less than the second distance (W2).

5. The semiconductor memory device according to claim 4, wherein a size of a portion of the first sub-lower electrode (132_1) that is in the one of the plurality of supporter holes (150_H) is different from a size of a portion of the third sub-lower electrode (132_3) that is in the one of the plurality of supporter holes (150_H).

6. The semiconductor memory device according to claim 5, wherein the size of the portion of the first sub-lower electrode (132_1) is greater than the size of the portion of the third sub-lower electrode (132_3).

7. The semiconductor memory device according to any one of claims 4 to 6,
wherein the plurality of second lower electrodes (134) include a fifth sub-lower electrode (134_1) adjacent to the first sub-lower electrode (132_1) in the third direction (D1) and a sixth sub-lower electrode (134_2) adjacent to the fifth sub-lower electrode (134_1) in the third direction (D1), and
wherein a distance from the first sub-lower electrode (132_1) to the fifth sub-lower electrode (134_1) is less than a distance from the fifth sub-lower electrode (134_1) to the sixth sub-lower electrode (134_2).

8. The semiconductor memory device according to any one of claims 4 to 7, further comprising a landing pad (120, LP) between the substrate (100, 300, 400) and a lower electrode among the plurality of lower electrodes (130) and electrically connected to the lower electrode,
wherein the first sub-lower electrode (132_1) includes a first side surface adjacent to the one of the plurality of supporter holes (150_H),
wherein the third sub-lower electrode (132_3) includes a second side surface adjacent to the one of the plurality of supporter holes (150_H), and
with respect to an extension line perpendicular to an upper surface of the landing pad, a slope of the first side surface is greater than a slope of the second side surface.

9. The semiconductor memory device according to any one of claims 4 to 8, wherein at least three of the plurality of second lower electrodes (134) are between two adjacent supporter holes of the plurality of supporter holes (150_H) in the third direction (D1).

10. The semiconductor memory device according to any one of claims 4 to 9, wherein two of the plurality of second lower electrodes (134) are between two adjacent supporter holes of the plurality of supporter holes (150_H) in the fourth direction (D2).

11. The semiconductor memory device according to any one of claims 1 to 10,
wherein at least one second lower electrode among the plurality of second lower electrodes (134) is between two adjacent supporter holes of the plurality of supporter holes (150_H), and
wherein the two adjacent supporter holes are adjacent in the first direction (D6).

12. The semiconductor memory device according to any one of claims 1 to 7, further comprising:
a landing pad between the substrate (100, 300, 400) and a lower electrode among the plurality of lower electrodes (130) and electrically connected to the lower electrode;
an upper electrode (180) on the lower electrode; and
a dielectric film (160) between the lower electrode and the upper electrode (180).

13. A semiconductor memory device comprising:
a substrate (100);
a plurality of lower electrodes on the substrate (100); and
a supporter connecting the plurality of lower electrodes (130) to each other,
wherein the supporter includes a plurality of supporter holes adjacent to some of the plurality of lower electrodes (130),
wherein the plurality of lower electrodes (130) include a plurality of first lower electrodes (132) adjacent to the plurality of supporter holes and a plurality of second lower electrodes (134) spaced apart from the plurality of supporter holes (150_H),
wherein the plurality of supporter holes (150H) are aligned and spaced apart from each other by a first distance in a first direction (D1),
wherein the plurality of supporter holes (150_H) are aligned and spaced apart from each other by a second distance different from the first distance in a second direction (D2) perpendicular to the first direction (D1), and
wherein a number of the second lower electrodes (134) between a first pair of adjacent supporter holes of the plurality of supporter holes (150_H) in the first direction (D1) is greater than a number of the second lower electrodes (134) between a second pair of adjacent supporter holes of the plurality of supporter holes (150_H) in the second direction (D2).

14. The semiconductor memory device according to claim 13, wherein a perimeter of each of the plurality of supporter holes has four of the plurality of lower electrodes (130) thereon.

15. The semiconductor memory device according to claim 13 or 14,
wherein the plurality of supporter holes (150_H) are spaced apart from each other in a third direction (D6) and a fourth direction (D7) crossing the third direction (D6),
wherein the third direction (D3) crosses the first direction (D1) and the second direction (D2), and
wherein a number of the second lower electrodes (134) between a third pair of adjacent supporter holes of the plurality of supporter holes (150_H) in the third direction (D6) is equal to a number of the second lower electrodes (134) between a fourth pair of adjacent supporter holes of the plurality of supporter holes (150_H) in the fourth direction (D7).

## Amended claims

### Amended claims in accordance with Rule 137(2) EPC.

1. A semiconductor memory device comprising:
a substrate (100, 300, 400);
an interlayer insulating film (105) on the substrate (100);
an etching stop film (125) on the interlayer insulating film (105);
a plurality of lower electrodes (130) on the substrate (100, 300, 400); and
a first supporter (150) and a second supporter (152) and third supporter (154) each of the first to third supporters (150, 152, 154) connecting the plurality of lower electrodes (130) to each other,
wherein each of the first to third supporters (150, 152, 154) include a plurality of supporter holes (150_H) adjacent to some of the plurality of lower electrodes (130),
wherein the plurality of lower electrodes (130) include a plurality of first lower electrodes (132) adjacent to the plurality of supporter holes (150_H) and a plurality of second lower electrodes (134) spaced apart from the plurality of supporter holes (150_H),
wherein four adjacent first lower electrodes (132_1, 132_2, 132_3, 132_4) of the plurality of first lower electrodes (132) are adjacent to one of the plurality of supporter holes (150_H);
a landing pad (120) between the substrate (100, 300, 400) and a lower electrode among the plurality of lower electrodes (130) and electrically connected to the lower electrode, wherein the etching stop film (125) includes openings exposing at least the portions of the landing pads (120);
an upper electrode (180) on the lower electrode (130);
a dielectric film (160) between the lower electrode and the upper electrode (180); and
a conductive film (170) covering the dielectric film (160) and extending along a profile of the dielectric film (160),
wherein the plurality of supporter holes (150_H) are at equal intervals in a first direction (D6) and a second direction (D7) crossing the first direction (D6), and
wherein the first to third supporters (150, 152, 154) are sequentially disposed on the etching stop film (125) and wherein the dielectric film (160), the conductive film (170) and the upper electrode (180) are disposed between the first supporter (150) and the second supporter (152), between the second supporter (152) and the third supporter (154), and between the third supporter (154) and the etching stop film (125), respectively.

2. The semiconductor memory device according to claim 1, wherein each of the plurality of supporter holes (150_H) is surrounded by the plurality of second lower electrodes (134).

3. The semiconductor memory device according to claim 1 or 2, wherein a ratio of a number of the plurality of first lower electrodes (132) to a number of the plurality of second lower electrodes (134) is 1:1.

4. The semiconductor memory device according to any one of claims 1 to 3,
wherein the four adjacent first lower electrodes (132_1, 132_2, 132_3, 132_4) include first to fourth sub-lower electrodes, respectively, that are on a perimeter of the one of the plurality of supporter holes (150_,
wherein the first sub-lower electrode (132_1) is spaced apart from the second sub-lower electrode (132_2) by a first distance (W1) in a third direction (D1),
wherein the third sub-lower electrode (132_3) is spaced apart from the fourth sub-lower electrode (132_4) by a second distance (W2) in a fourth direction (D2) perpendicular to the third direction (D1),
wherein the first to fourth directions (D6, D7, D1, D2) cross each other, and
wherein the first distance (W1) is less than the second distance (W2).

5. The semiconductor memory device according to claim 4, wherein a size of a portion of the first sub-lower electrode (132_1) that is in the one of the plurality of supporter holes (150_H) is different from a size of a portion of the third sub-lower electrode (132_3) that is in the one of the plurality of supporter holes (150_H).

6. The semiconductor memory device according to claim 5, wherein the size of the portion of the first sub-lower electrode (132_1) is greater than the size of the portion of the third sub-lower electrode (132_3).

7. The semiconductor memory device according to any one of claims 4 to 6,
wherein the plurality of second lower electrodes (134) include a fifth sub-lower electrode (134_1) adjacent to the first sub-lower electrode (132_1) in the third direction (D1) and a sixth sub-lower electrode (134_2) adjacent to the fifth sub-lower electrode (134_1) in the third direction (D1), and
wherein a distance from the first sub-lower electrode (132_1) to the fifth sub-lower electrode (134_1) is less than a distance from the fifth sub-lower electrode (134_1) to the sixth sub-lower electrode (134_2).

8. The semiconductor memory device according to any one of claims 4 to 7, further comprising a landing pad (120, LP) between the substrate (100, 300, 400) and a lower electrode among the plurality of lower electrodes (130) and electrically connected to the lower electrode,
wherein the first sub-lower electrode (132_1) includes a first side surface adjacent to the one of the plurality of supporter holes (150_H),
wherein the third sub-lower electrode (132_3) includes a second side surface adjacent to the one of the plurality of supporter holes (150_H), and
with respect to an extension line perpendicular to an upper surface of the landing pad, a slope of the first side surface is greater than a slope of the second side surface.

9. The semiconductor memory device according to any one of claims 4 to 8, wherein at least three of the plurality of second lower electrodes (134) are between two adjacent supporter holes of the plurality of supporter holes (150_H) in the third direction (D1).

10. The semiconductor memory device according to any one of claims 4 to 9, wherein two of the plurality of second lower electrodes (134) are between two adjacent supporter holes of the plurality of supporter holes (150_H) in the fourth direction (D2).

11. The semiconductor memory device according to any one of claims 1 to 10,
wherein at least one second lower electrode among the plurality of second lower electrodes (134) is between two adjacent supporter holes of the plurality of supporter holes (150_H), and
wherein the two adjacent supporter holes are adjacent in the first direction (D6).
